# EUROPEAN PATENT APPLICATION

(11) **EP 4 687 392 A1**
(43) Date of publication of application: **04.02.2026**
(21) Application number: 25171915.9
(22) Date of filing: 23.04.2025
(51) Int. Cl.: H10B 12/00

(54) **SEMICONDUCTOR MEMORY DEVICE**

(30) Priority: 31.07.2024 KR 20240102029
(71) Applicant: Samsung Electronics Co., Ltd., Suwon-si, Gyeonggi-do 16677 (KR)
(72) Inventor: AHN, Sangbin, 16677 Suwon-si, Gyeonggi-do (KR); KIM, Jiyoung, 16677 Suwon-si, Gyeonggi-do (KR)
(74) Representative: Kuhnen & Wacker Patent- und Rechtsanwaltsbüro PartG mbB

(57) **Abstract**

A semiconductor memory device may (100) include a bit line (BL) extending lengthwise in a first horizontal direction (X) on a first plane; a channel structure (106A) on a second plane apart from the first plane in a vertical direction (Z), the channel structure (106A) being shifted from the bit line (BL) in a second horizontal direction (Y) in a plan view and not overlapping the bit line (BL) in the vertical direction (Z), and the second horizontal direction (Y) being orthogonal to the first horizontal direction (X); an insulating structure (104, 112, 114) between the bit line (BL) and the channel structure (106A), the insulating structure (104, 112, 114) filling a space between the first plane and the second plane; and a contact plug (120) passing through the insulating structure (104, 112, 114) in the vertical direction (Z). A bottom surface of the contact plug (120) may be in contact with an upper surface of the bit line (BL). An upper sidewall of the contact plug (120) may be in contact with the channel structure (106A).

## Description

### BACKGROUND

Inventive concepts relate to a semiconductor memory device, and more particularly, to a semiconductor memory device including a vertical channel transistor.

Due to recent advances in electronics technology, semiconductor memory devices have been rapidly down-scaled. Accordingly, finer-sized memory cells may be required. There may be a limit for existing memory cells to be more highly integrated and maintain the reliability thereof. Therefore, developing a semiconductor memory device having a structure that facilitates the miniaturization and/or higher integration of memory cells may be needed.

### SUMMARY

Inventive concepts provide a semiconductor memory device having a structure that may facilitate the miniaturization and/or higher integration of memory cells, which may lower the possibility of short circuits between adjacent conductive regions when components for forming a vertical channel transistor are arranged in a relatively smaller area along with the miniaturization and/or higher integration.

According to an embodiment of inventive concepts, a semiconductor memory device may include a bit line extending lengthwise in a first horizontal direction on a first plane; a channel structure on a second plane that may be apart from the first plane in a vertical direction, the channel structure being shifted from the bit line in a second horizontal direction in a plan view and not overlapping the bit line in the vertical direction, and the second horizontal direction being orthogonal to the first horizontal direction; an insulating structure between the bit line and the channel structure, the insulating structure filling a space between the first plane and the second plane; and a contact plug passing through the insulating structure in the vertical direction. A bottom surface of the contact plug may be in contact with an upper surface of the bit line. An upper sidewall of the contact plug may be in contact with the channel structure.

According to an embodiment of inventive concepts, a semiconductor memory device may include a base insulating film; and a memory cell array including a plurality of memory cells repeatedly arranged on the base insulating film in a first horizontal direction and a second horizontal direction that may be orthogonal to each other. The memory cell array may include a plurality of bit lines in the base insulating film and each extending lengthwise in the first horizontal direction on a first plane on the base insulating film, the plurality of bit lines being apart from each other in the second horizontal direction; a plurality of channel structures repeatedly arranged in the first horizontal direction and the second horizontal direction on a second plane that may be apart from the first plane on the base insulating film in a vertical direction; an insulating structure between the plurality of bit lines and the plurality of channel structures, the insulating structure filling a space between the first plane and the second plane; and a plurality of contact plugs passing through the insulating structure in the vertical direction. A bottom surface of each of the plurality of contact plugs may be in contact with an upper surface of an underlying bit line among the plurality of bit lines. An upper sidewall of each of the plurality of contact plugs may be in contact with an adjacent one of the plurality of channel structures. Each of the plurality of channel structures may be shifted in the second horizontal direction from an adjacent one of the plurality of bit lines and may not overlap the adjacent one of the plurality of bit lines in the vertical direction.

According to an embodiment of inventive concepts, a semiconductor memory device may include a base insulating film; a bit line extending lengthwise in a first horizontal direction on a first plane on the base insulating film; a channel structure including a horizontal channel portion and a pair of vertical channel portions integrally connected to the horizontal channel portion, the horizontal channel portion having a nonlinear recess sidewall and extending along a second plane that may be apart from the first plane in a vertical direction, and the pair of vertical channel portions respectively extending from both ends of the horizontal channel portion in a direction away from the horizontal channel portion in the vertical direction, the both ends of the horizontal channel portion being based on the first horizontal direction; an insulating structure between the bit line and the channel structure and filling a space between the first plane and the second plane; a contact plug passing through the insulating structure in the vertical direction, a bottom surface of the contact plug being in contact with an upper surface of the bit line, and an upper sidewall of the contact plug being in contact with the nonlinear recess sidewall of the horizontal channel portion; a pair of word lines over the channel structure and respectively facing the pair of vertical channel portions in the first horizontal direction; and a pair of gate dielectric films between the channel structure and the pair of word lines. Each of the channel structure, the pair of word lines, and the pair of gate dielectric films may be shifted from the bit line in a second horizontal direction in a plan view and may not overlap the bit line in the vertical direction. The second horizontal direction may cross the first horizontal direction.

### BRIEF DESCRIPTION OF THE DRAWINGS

Embodiments will be more clearly understood from the following detailed description taken in conjunction with the accompanying drawings in which:
FIG. 1 is a planar layout diagram illustrating some components of a semiconductor memory device according to embodiments;
FIG. 2 is a cross-sectional view of components of the semiconductor memory device of FIG. 1, taken along a line X1-X1' of FIG. 1;
FIG. 3 is a cross-sectional view of components of the semiconductor memory device of FIG. 1, taken along a line X2-X2' of FIG. 1;
FIG. 4 is a cross-sectional view of components of the semiconductor memory device of FIG. 1, taken along a line Y1-Y1' of FIG. 1;
FIG. 5 is an enlarged cross-sectional view of some components in a region EX1 of FIG. 1;
FIG. 6 is an enlarged cross-sectional view of a region EX2 of FIG. 2;
FIG. 7 is a cross-sectional view illustrating a semiconductor memory device according to some embodiments;
FIG. 8 is a cross-sectional view illustrating a semiconductor memory device according to some embodiments;
FIG. 9 is a cross-sectional view illustrating a semiconductor memory device according to some embodiments;

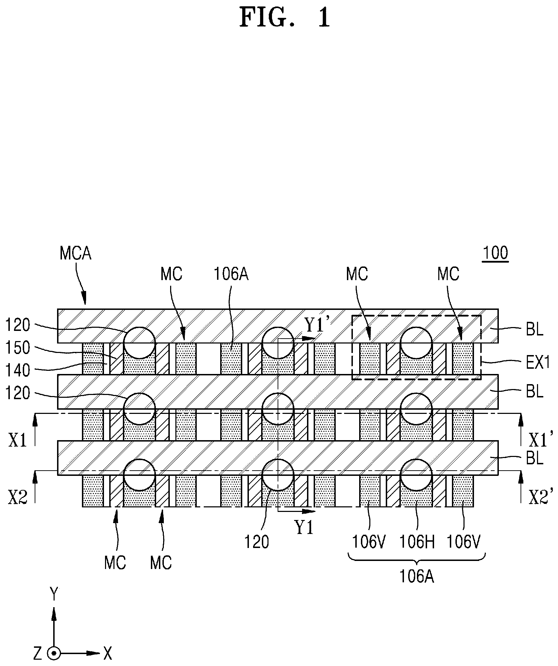

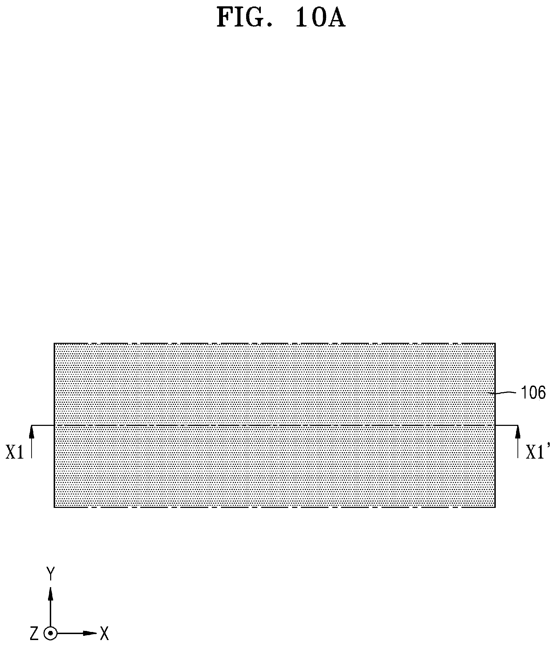

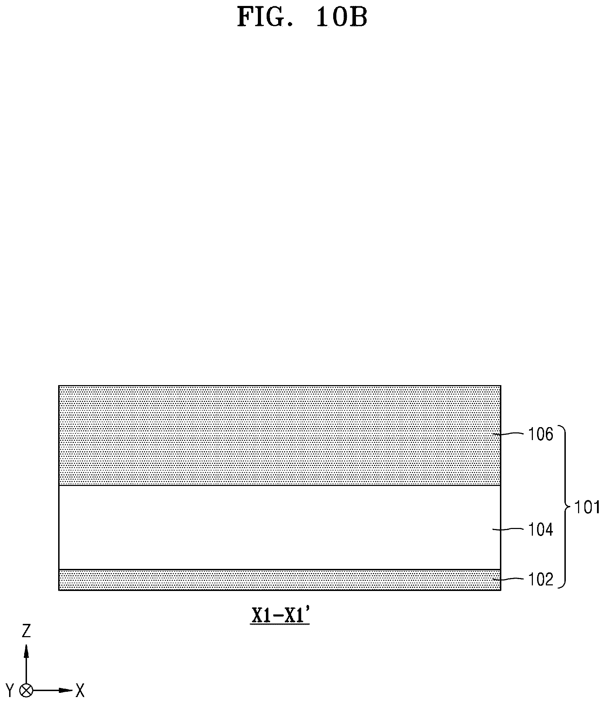

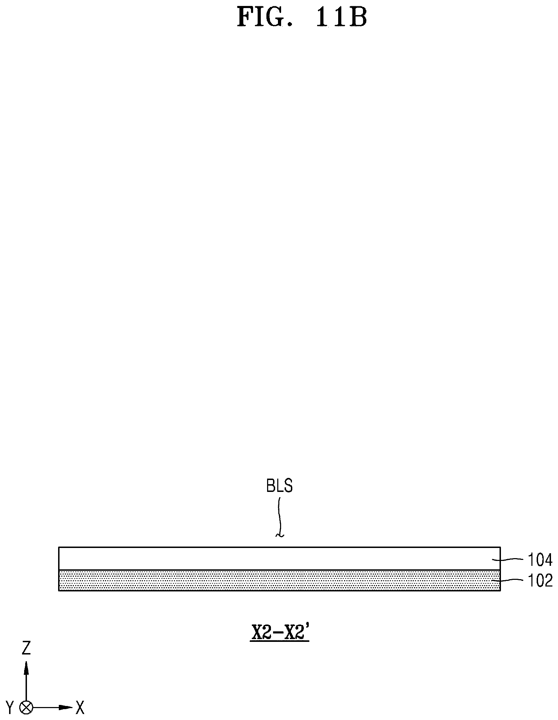

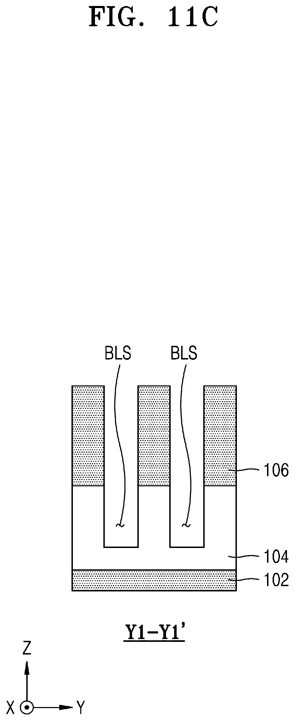

FIGS. 10A to 24 are diagrams respectively illustrating a sequence of processes of a method of fabricating a semiconductor memory device, according to embodiments, and in particularly, FIGS. 10A, 11A, 12A, 13A, 14A, 15A, 16A, 17A, and 18A are plan views each illustrating some components according to the sequence of processes of the method of fabricating a semiconductor memory device, FIGS. 10B, 14B, 15B, 16B, 17B, 18B, 19, 20, 21, 22A, 23, and 24 are cross-sectional views each illustrating a region corresponding to the cross-section taken along the line X1-X1' of FIG. 1, according to the sequence of processes, FIGS. 11B, 12B, 13B, 14C, 15C, 16C, and 17C are cross-sectional views each illustrating a region corresponding to the cross-section taken along the line X2-X2' of FIG. 1, according to the sequence of processes, and FIGS. 11C, 12C, 13C, 14D, 15D, 16D, 17D, 18C, and 22B are cross-sectional views each illustrating a region corresponding to the cross-section taken along the line Y1-Y1' of FIG. 1, according to the sequence of processes;
FIG. 25 is a cross-sectional view illustrating a method of fabricating a semiconductor memory device, according to some embodiments; and
FIGS. 26 and 27 are cross-sectional views respectively illustrating a sequence of processes of a method of fabricating a semiconductor memory device, according to some embodiments.

### DETAILED DESCRIPTION

The notion that elements are "substantially the same" may indicate that the element may be completely the same and may also indicate that the elements may be determined to be the same in consideration of errors or deviations occurring during a process. Hereinafter, embodiments of inventive concepts will be described in detail with reference to the accompanying drawings. Like components are denoted by like reference numerals throughout the specification, and repeated descriptions thereof are omitted.

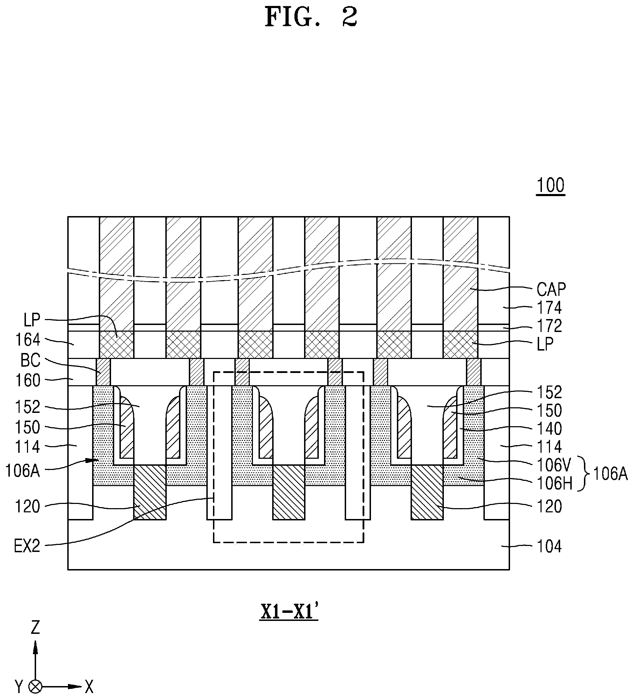

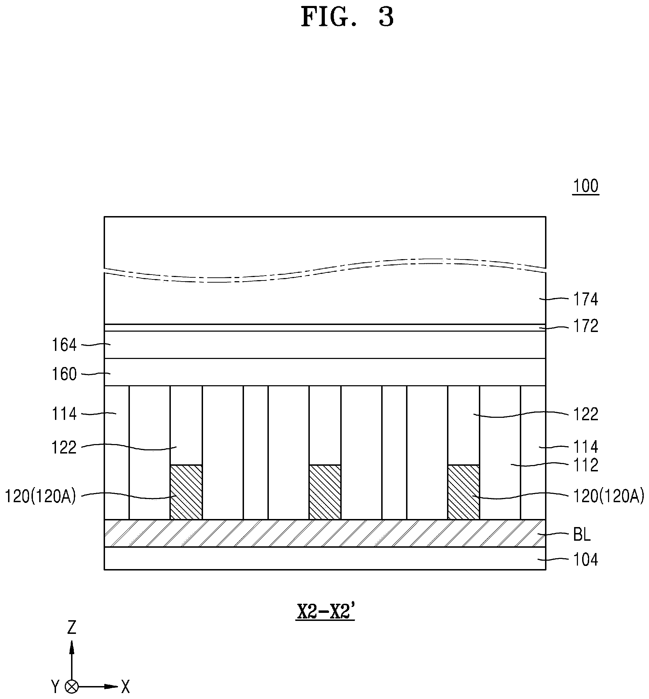

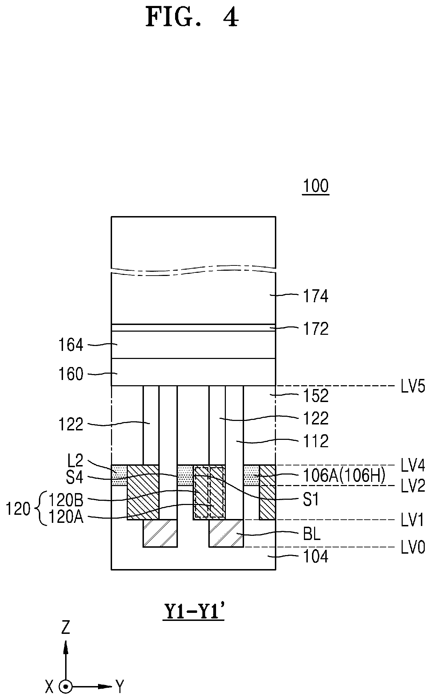

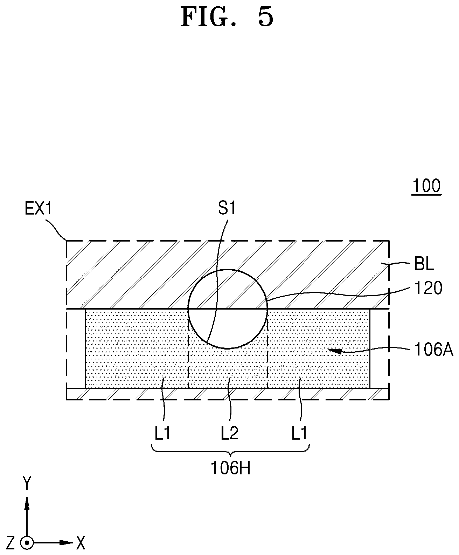

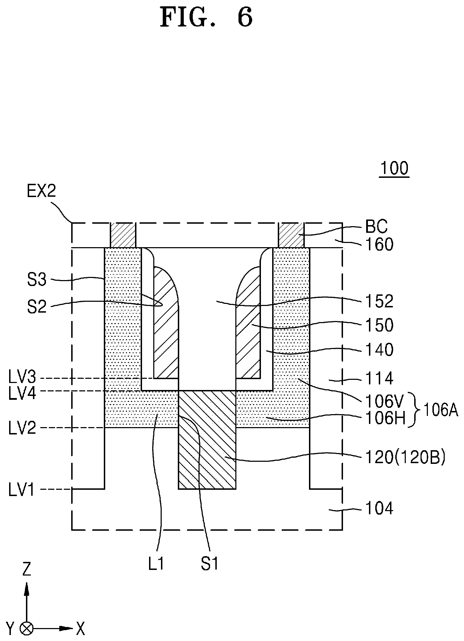

FIGS. 1 to 6 are diagrams illustrating a semiconductor memory device 100 according to embodiments. More specifically, FIG. 1 is a planar layout diagram illustrating some components of the semiconductor memory device 100. FIG. 2 is a cross-sectional view of components of the semiconductor memory device 100, taken along a line X1-X1' of FIG. 1. FIG. 3 is a cross-sectional view of components of the semiconductor memory device 100, taken along a line X2-X2' of FIG. 1. FIG. 4 is a cross-sectional view of components of the semiconductor memory device 100, taken along a line Y1-Y1' of FIG. 1. FIG. 5 is an enlarged cross-sectional view of some components in a region EX1 of FIG. 1. FIG. 6 is an enlarged cross-sectional view of a region EX2 of FIG. 2.

Referring to FIGS. 1 to 6, the semiconductor memory device 100 includes a memory cell array MCA including a plurality of memory cells MC. In the memory cell array MCA, the plurality of memory cells MC may be repeatedly arranged on a base insulating film 104 in a first horizontal direction (an X direction or a -X direction) and a second horizontal direction (a Y direction or a -Y direction) that are orthogonal to each other.

The memory cell array MCA may include a plurality of bit lines BL buried in the base insulating film 104. The lower surface of each of the plurality of bit lines BL may be located in an imaginary first plane extending in a horizontal direction (a direction along the X-Y plane) at a reference vertical level LV0 that is a lower vertical level than the uppermost surface of the base insulating film 104. Each of the plurality of bit lines BL may extend lengthwise in the first horizontal direction (the X direction or the -X direction) on the imaginary first plane. The plurality of bit lines BL may extend parallel to each other to be apart from each other in the second horizontal direction (the Y direction or the -Y direction). The reference vertical level LV0, at which the lower surface of each of the plurality of bit lines BL is located, may be the lowermost vertical level of each of the plurality of memory cells MC that are included in the memory cell array MCA. The upper surface of each of the plurality of bit lines BL may be at a first vertical level LV1 that is higher than the reference vertical level LV0. The lower surface and sidewalls of each of the plurality of bit lines BL may be covered by the base insulating film 104.

In some embodiments, the base insulating film 104 may include a silicon oxide film. Each of the plurality of bit lines BL may include a metal, a conductive metal nitride, a metal silicide, polysilicon, or a combination thereof. For example, each of the plurality of bit lines BL may include, but is not limited to, Ti, TiN, Ta, TaN, Mo, Ru, W, WN, Co, Ni, TiSi, TiSiN, WSi, WSiN, TaSi, TaSiN, RuTiN, CoSi, NiSi, polysilicon, or a combination thereof.

The memory cell array MCA may include a plurality of channel regions 106A arranged on the base insulating film 104. The plurality of channel regions 106A may be repeatedly arranged in the first horizontal direction (the X direction or the -X direction) and the second horizontal direction (the Y direction or the -Y direction) on an imaginary second plane that is apart from the imaginary first plane in a vertical direction (a Z direction). The imaginary second plane may be a plane extending in the horizontal direction (the direction along the X-Y plane) at a second vertical level LV2 that is higher than the reference vertical level LV0 and the first vertical level LV1. A separation distance in the vertical direction (the Z direction) between the first vertical level LV1 and the second vertical level LV2 may be greater than 0. In some embodiments, the separation distance in the vertical direction (the Z direction) between the first vertical level LV1 and the second vertical level LV2 may be at least greater than the thickness of a bit line BL in the vertical direction (the Z direction).

Each of the plurality of channel regions 106A may be arranged to be shifted in the second horizontal direction (the Y direction or the -Y direction) from a bit line BL adjacent thereto from among the plurality of bit lines BL in a plan view not to overlap the adjacent bit line BL in the vertical direction (the Z direction).

An insulating structure may be arranged between the plurality of bit lines BL and the plurality of channel regions 106A. The insulating structure may fill a space between the imaginary first plane and the imaginary second plane. The insulating structure may include a base insulating film 104, a plurality of first isolation insulating films 112, and a plurality of second isolation insulating films 114. The channel region(s) 106A may be referred to as channel structure(s) 106A.

A plurality of contact plugs 120 may be arranged between the plurality of bit lines BL and the plurality of channel regions 106A to pass through the insulating structure in the vertical direction (the Z direction). As shown in FIGS. 2, 3, 4, and 6, each of the plurality of contact plugs 120 may have a bottom surface, which is in contact with the upper surface of one bit line BL selected from the plurality of bit lines BL, and an upper sidewall, which is in contact with one channel region 106A selected from the plurality of channel regions 106A.

As shown in detail in FIG. 4, each of the plurality of contact plugs 120 may include a first plug portion 120A overlapping, in the vertical direction (the Z direction), one bit line BL adjacent thereto from among the plurality of bit lines BL, and a second plug portion 120B integrally connected to the first plug portion 120A and overlapping none of the plurality of bit lines BL and the plurality of channel regions 106A in the vertical direction (the Z direction).

In each of the plurality of contact plugs 120, the lower surface of the first plug portion 120A and the lower surface of the second plug portion 120B may constitute the lowermost surface of the contact plug 120. The lower surface of the first plug portion 120A, the lower surface of the second plug portion 120B, and the upper surface of each of the plurality of bit lines BL may each extend in the horizontal direction at the first vertical level LV1. The lower surface of the first plug portion 120A of each of the plurality of contact plugs 120 may be in contact with the upper surface of the bit line BL adjacent thereto. The lower surface of the second plug portion 120B may be arranged to be shifted in the second horizontal direction (the Y direction or the -Y direction) from the adjacent bit line BL. The lower surface of the second plug portion 120B may be in contact with the base insulating film 104.

As shown in FIGS. 2, 4, 5, and 6, each of the plurality of channel regions 106A may include a horizontal channel region 106H, which also may be referred to as a horizontal channel portion 106H, and a pair of vertical channel regions 106V, which also may be referred to as vertical channel portion(s) 106V. In each of the plurality of channel regions 106A, the horizontal channel region 106H may extend in the first horizontal direction (the X direction or the -X direction) along the imaginary second plane that extends in the horizontal direction (the direction along the X-Y plane) at the second vertical level LV2. In each of the plurality of channel regions 106A, the pair of vertical channel regions 106V may respectively extend from both ends, based on the first horizontal direction (the X direction or the -X direction), of the horizontal channel region 106H in a direction away from the horizontal channel region 106H in the vertical direction (the Z direction). Each of the plurality of channel regions 106A may have a structure in which the horizontal channel region 106H is integrally connected to the pair of vertical channel regions 106V.

As shown in FIGS. 4, 5, and 6, each of the plurality of channel regions 106A may include a nonlinear recess sidewall S1 and a linear sidewall S4, which are included in the horizontal channel region 106H, and an inner sidewall S2 and an outer sidewall S3, which are included in a vertical channel region 106V. In the horizontal channel region 106H, the nonlinear recess sidewall S1 and the linear sidewall S4 may be located opposite to each other in the second horizontal direction (the Y direction or the -Y direction). In the vertical channel region 106V, the inner sidewall S2 and the outer sidewall S3 may be located opposite to each other in the first horizontal direction (the X direction or the -X direction).

In each of the plurality of channel regions 106A, the nonlinear recess sidewall S1 of the horizontal channel region 106H may be in contact with an upper sidewall of the second plug portion 120B of the contact plug 120 adjacent thereto. Each of the plurality of channel regions 106A may not be in contact with the first plug portion 120A of each of the plurality of contact plugs 120.

As shown in FIG. 4, in the insulating structure arranged between the plurality of bit lines BL and the plurality of channel regions 106A, the base insulating film 104 may include portions covering the lower surface and the sidewalls of each of the plurality of bit lines BL, portions covering the lower surface of the each of the plurality of channel regions 106A, and portions covering the lower surface and the sidewall of the second plug portion 120B of each of the plurality of contact plugs 120.

As shown in FIGS. 3 and 4, the plurality of first isolation insulating films 112 may be arranged in a line to be apart from each other in the first horizontal direction (the X direction or the -X direction) and the second horizontal direction (the Y direction or the -Y direction). Each of the plurality of first isolation insulating films 112 may have a surface contacting the upper surface of the bit line BL adjacent thereto, a surface contacting the sidewall of the first plug portion 120A of the contact plug 120 adjacent thereto, and a surface contacting the linear sidewall S4 of the horizontal channel region 106H that is a portion of the channel region 106A adjacent thereto.

As shown in FIGS. 2 and 3, the plurality of second isolation insulating films 114 may be arranged in a line to be apart from each other in the first horizontal direction (the X direction or the -X direction) and the second horizontal direction (the Y direction or the -Y direction). Each of the plurality of second isolation insulating films 114 may have a surface contacting the upper surface of the adjacent bit line BL and a surface contacting the outer sidewall S3 of the vertical channel region 106V that is another portion of the adjacent channel region 106A. As shown in FIG. 2, the width of the channel region 106A in the first horizontal direction (the X direction or the -X direction) may be defined by two adjacent second isolation insulating films 114 from among the plurality of second isolation insulating films 114.

In some embodiments, each of the plurality of channel regions 106A may include doped silicon. In some embodiments, each of the plurality of channel regions 106A may include an oxide semiconductor layer including InGaZnO (IGZO), Sn-IGZO, InWO (IWO), InZnO (IZO), ZnSnO (ZTO), ZnO, yttrium-doped zinc oxide (YZO), InGaSiO (IGSO), InO, SnO, TiO, ZnON, MgZnO, ZrInZnO, HfInZnO, SnInZnO, SiInZnO, GaZnSnO, ZrZnSnO, or a combination thereof.

In the insulating structure, each of the base insulating film 104, the plurality of first isolation insulating films 112, and the plurality of second isolation insulating films 114 may include an oxide film, a nitride film, or a combination thereof. For example, each of the base insulating film 104, the plurality of first isolation insulating films 112, and the plurality of second isolation insulating films 114 may include a silicon oxide film.

The semiconductor memory device 100 may include a plurality of word lines 150, which each face the channel region 106A adjacent thereto in the first horizontal direction (the X direction or the -X direction). Each of the plurality of word lines 150 may be arranged on an imaginary third plane extending in the horizontal direction (the direction along the X-Y plane) at a third vertical level LV3 above the base insulating film 104. The imaginary third plane is a plane that is apart from the imaginary second plane in a direction away from the adjacent bit line BL in the vertical direction (the Z direction), the imaginary second plane extending at the second vertical level LV2. A plurality of gate dielectric films 140 are arranged between the plurality of channel regions 106A and the plurality of word lines 150.

Each of the plurality of word lines 150 and the plurality of gate dielectric films 140 may be arranged to be shifted in the second horizontal direction (the Y direction or the -Y direction) from the bit line BL adjacent thereto from among the plurality of bit lines BL in a plan view not to overlap the adjacent bit line BL in the vertical direction (the Z direction).

As shown in FIG. 5, the horizontal channel region 106H may include a pair of first local portions L1 not overlapping a contact plug 120, which is adjacent thereto, in the second horizontal direction (the Y direction or the -Y direction) and a second local portion L2 overlapping the adjacent contact plug 120 in the second horizontal direction (the Y direction or the -Y direction). In one horizontal channel region 106H, the second local portion L2 may be arranged between the pair of first local portions L1. As shown in FIG. 6, a gate dielectric film 140 may be in contact with the inner sidewall S2 of the vertical channel region 106V and a surface of a first local portion L1 of the horizontal channel region 106H. As shown in FIG. 4, the gate dielectric film 140 may not be in contact with a surface of the second local portion L2 of the horizontal channel region 106H.

As shown in FIGS. 2, 4, and 6, the upper surface of the second local portion L2 of the horizontal channel region 106H and the upper surface of the contact plug 120, which contacts the nonlinear recess sidewall S1 of the second local portion L2, may extend along an imaginary fourth plane extending in the horizontal direction (the direction along the X-Y plane) equally at a fourth vertical level LV4 above the base insulating film 104. The fourth vertical level LV4 is a vertical level between the second vertical level LV2 and the third vertical level LV3.

Each of the plurality of word lines 150 may include, but is not limited to, Ti, TiN, Ta, TaN, Mo, Ru, W, WN, TiSiN, WSiN, polysilicon, or a combination thereof. Each of the plurality of gate dielectric films 140 may include a silicon oxide film or a high-k film having a higher dielectric constant than a silicon oxide film. In some embodiments, the gate dielectric film 140 may include at least one material selected from hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), tantalum oxide (TaO), titanium oxide (TiO), barium strontium titanium oxide (BaSrTiO), barium titanium oxide (BaTiO), lead zirconate titanate (PZT), strontium bismuth tantalate (STB), bismuth iron oxide (BFO), strontium titanium oxide (SrTiO), yttrium oxide (YO), aluminum oxide (AlO), and lead scandium tantalum oxide (PbScTaO).

As shown in FIGS. 2, 3, 4, and 6, a plurality of upper insulating partitions 152 may be respectively arranged on the plurality of contact plugs 120. One upper insulating partition 152 may be arranged on one contact plug 120. The lower surface of the upper insulating partition 152 may be in contact with the upper surface of the contact plug 120 corresponding thereto. Each of the plurality of upper insulating partitions 152 may be in contact with each of a pair of word lines 150 adjacent thereto and a pair of gate dielectric films 140 adjacent thereto.

As shown in FIG. 4, each of the plurality of upper insulating partitions 152 may include a portion overlapping a portion of the contact plug 120 in the vertical direction (the Z direction) and a portion overlapping a portion of the channel region 106A in the vertical direction (the Z direction). Each of the plurality of upper insulating partitions 152 may be arranged to be shifted in the second horizontal direction (the Y direction or the -Y direction) from the bit line BL adjacent thereto from among the plurality of bit lines BL in a plan view not to overlap the adjacent bit line BL in the vertical direction (the Z direction). Each of the plurality of upper insulating partitions 152 may include a silicon oxide film, a silicon nitride film, or a combination thereof.

As shown in FIGS. 3 and 4, in each of the plurality of contact plugs 120, the first plug portion 120A overlapping the bit line BL in the vertical direction (the Z direction) may be covered by a buried insulating film 122. The upper surface of the first plug portion 120A of each of the plurality of contact plugs 120 may be in contact with the lower surface of the buried insulating film 122. The buried insulating film 122 may include a silicon oxide film.

The upper surface of the first isolation insulating film 112, the upper surface of the buried insulating film 122, and the upper surface of the upper insulating partition 152 may extend along an imaginary fifth plane extending in the horizontal direction (the direction along the X-Y plane) equally at a fifth vertical level LV5 above the base insulating film 104. The imaginary fifth plane is a plane that is further apart from the bit line BL, which is adjacent thereto, in a direction away from the adjacent bit line BL in the vertical direction (the Z direction) than the imaginary third plane extending in the horizontal direction (the direction along the X-Y plane) at the third vertical level LV3.

As shown in FIG. 2, the semiconductor memory device 100 may further include a plurality of upper contact patterns BC, a plurality of conductive landing pads LP, and a plurality of capacitor structures CAP, which are arranged in the stated order on or over the plurality of channel regions 106A.

Each of the plurality of upper contact patterns BC may be in contact with the uppermost surface of the vertical channel region 106V of the channel region 106A adjacent thereto from among the plurality of channel regions 106A. The uppermost surface of the vertical channel region 106V may be a surface of the vertical channel region 106V, which is farthest from the bit line BL adj acent to the vertical channel region 106V. The plurality of upper contact patterns BC may be respectively connected to the uppermost surfaces of a plurality of vertical channel regions 106V that are included in the plurality of channel regions 106A.

Each of the plurality of upper contact patterns BC may include a metal-containing film. In some embodiments, each of the plurality of upper contact patterns BC may include Ti, TiN, Ta, TaN, Mo, Ru, W, WN, TiSiN, WSiN, or a combination thereof. For example, each of the plurality of upper contact patterns BC may include a stack structure of a conductive barrier film including TiN and a conductive film including W. The plurality of upper contact patterns BC may be insulated from each other by a first insulating film 160. As shown in FIG. 4, the upper surface of each of the first isolation insulating film 112, the buried insulating film 122, and the upper insulating partition 152 may be in contact with the lower surface of the first insulating film 160. The first insulating film 160 may include a silicon oxide film, a silicon nitride film, or a combination thereof.

For each of the plurality of conductive landing pads LP, one conductive landing pad LP may be connected to the upper surface of one contact pattern BC selected from the plurality of upper contact patterns BC. The plurality of conductive landing pads LP arranged in a line in the first horizontal direction (the X direction or the -X direction) may be arranged at regular pitches. In some embodiments, each of the plurality of conductive landing pads LP may include a metal-containing film. In some embodiments, each of the plurality of conductive landing pads LP may include Ti, TiN, Ta, TaN, Mo, Ru, W, WN, TiSiN, WSiN, or a combination thereof. The plurality of conductive landing pads LP may be insulated from each other by a second insulating film 164. The second insulating film 164 may include a silicon oxide film, a silicon nitride film, or a combination thereof.

An etch stop film 172 and an interlayer dielectric 174 may be stacked in the stated order on the plurality of conductive landing pads LP and the second insulating film 164. The etch stop film 172 may include a silicon nitride film and the interlayer dielectric 174 may include a silicon nitride film, but inventive concepts are not limited thereto.

For each of the plurality of capacitor structures CAP, one capacitor structure CAP may pass through the interlayer dielectric 174 and the etch stop film 172 in the vertical direction (the Z direction) and be connected to the upper surface of one conductive landing pad LP selected from the plurality of conductive landing pads LP. Each of the plurality of capacitor structures CAP may be configured to be connected to one upper contact pattern BC, which is selected from the plurality of upper contact patterns BC, via one conductive landing pad LP selected from the plurality of conductive landing pads LP.

In the semiconductor memory device 100 described with reference to FIGS. 1 to 6, two adjacent memory cells MC in the first horizontal direction (the X direction or the -X direction) from among the plurality of memory cells MC may share one channel region 106A, which is selected from the plurality of channel regions 106A, and one contact plug 120, which is selected from the plurality of contact plugs 120 and in contact with the selected one channel region 106A.

In the semiconductor memory device 100 described with reference to FIGS. 1 to 6, the plurality of bit lines BL are arranged at a lower vertical level (the reference vertical level LV0) above the base insulating film 104, and the plurality of channel regions 106A are arranged at an upper vertical level (the second vertical level LV2), which is sufficiently apart from the lower vertical level in the vertical direction (the Z direction), such that a sufficient insulation distance in the vertical direction (the Z direction) from the plurality of bit lines BL may be secured. In addition, in the semiconductor memory device 100 according to embodiments, the bit line BL and the channel region 106A are arranged to be shifted from each other in the second horizontal direction (the Y direction or the -Y direction) in a plan view not to overlap each other in the vertical direction (the Z direction). The bit line BL and the channel region 106A may be connected to each other via the contact plug 120 extending lengthwise in the vertical direction (the Z direction) from the upper surface of the bit line BL to the nonlinear recess sidewall S1 of the horizontal channel region 106H of the channel region 106A. The semiconductor memory device 100 according to embodiments may provide a structure facilitating the miniaturization and higher integration of memory cells MC and capable of removing the possibility of an unintended short circuit between adjacent conductive regions, for example, the possibility of an unintended short circuit between the bit line BL and the channel region 106A adjacent thereto, even when components necessary to form a vertical channel transistor are arranged in a relatively small area due to the miniaturization and higher integration.

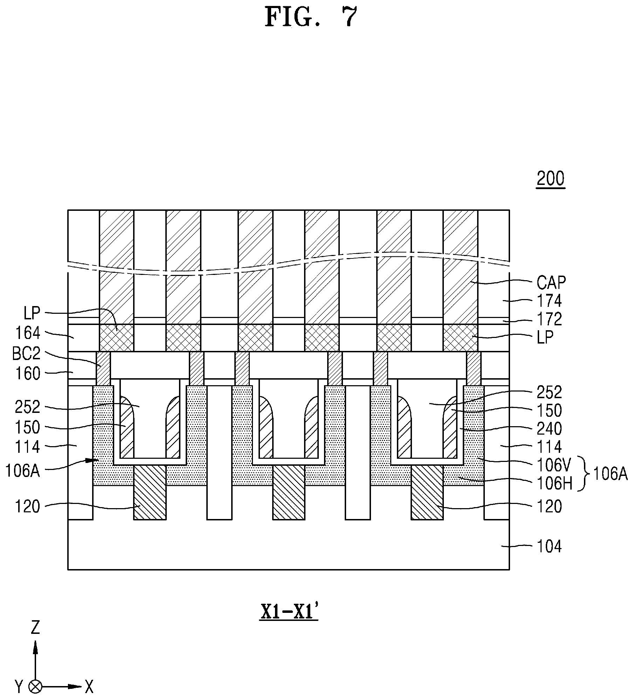

FIG. 7 is a cross-sectional view illustrating a semiconductor memory device 200 according to some embodiments. FIG. 7 illustrates components in a portion of the semiconductor memory device 200, the portion corresponding to the cross-section taken along the line X1-X1' of FIG. 1. In FIG. 7, the same reference numerals as in FIGS. 1 to 6 respectively denote the same members, and here, repeated descriptions thereof are omitted.

Referring to FIG. 7, the semiconductor memory device 200 has substantially the same configuration as the semiconductor memory device 100 described with reference to FIGS. 1 to 6. However, the semiconductor memory device 200 includes a plurality of gate dielectric films 240 and a plurality of upper insulating partitions 252.

The plurality of gate dielectric films 240 may have substantially the same configuration as the plurality of gate dielectric films 140 described with reference to FIGS. 2 and 6. However, each of the plurality of gate dielectric films 240 may include a portion contacting a surface (a surface corresponding to the inner sidewall S2 of the vertical channel region 106V shown in FIG. 6) of the inner sidewall S2 of the vertical channel region 106V of the channel region 106A, a portion contacting a surface (a surface corresponding to the first local portion L1 of the horizontal channel region 106H shown in FIG. 6) of the horizontal channel region 106H of the channel region 106A, a portion contacting the upper surface of the contact plug 120, and a portion contacting the upper surface of the second isolation insulating film 114. A plurality of upper contact patterns BC2 may each pass through the first insulating film 160 and the gate dielectric film 240 in the vertical direction (the Z direction) to be in contact with the uppermost surface of the vertical channel region 106V of a channel region 106A, which is adjacent to each upper contact pattern BC2, from among the plurality of channel regions 106A.

Each of the plurality of gate dielectric films 240 may include a silicon oxide film. A more detailed configuration of the plurality of upper contact patterns BC2 is substantially the same as that of the plurality of upper contact patterns BC described with reference to FIG. 2.

Two word lines 150, which respectively constitute different memory cells, may be in contact with one gate dielectric film 240. One upper insulating partition 252 selected from the plurality of upper insulating partitions 252 may be arranged on one gate dielectric film 240 and two word lines 150 contacting the one gate dielectric film 240. The upper insulating partition 252 may be in contact with one gate dielectric film 240 adjacent thereto and two word lines 150 adjacent thereto. The upper insulating partition 252 may be apart from the contact plug 120 in the vertical direction (the Z direction) with the gate dielectric film 240 therebetween. A more detailed configuration of the plurality of upper insulating partitions 252 is substantially the same as that of the plurality of upper insulating partitions 152 described with reference to FIGS. 2, 4, and 6.

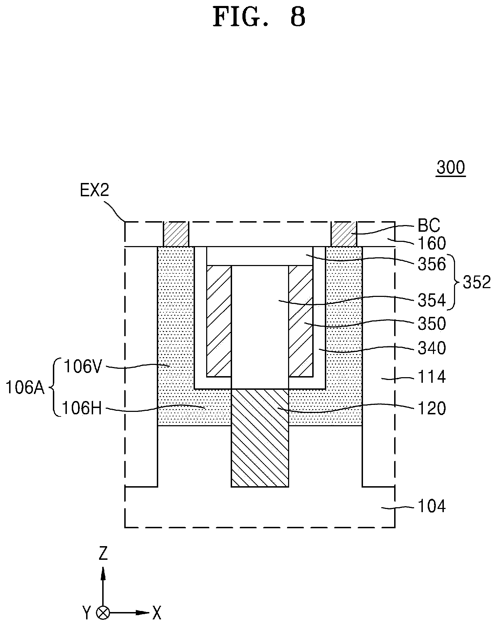

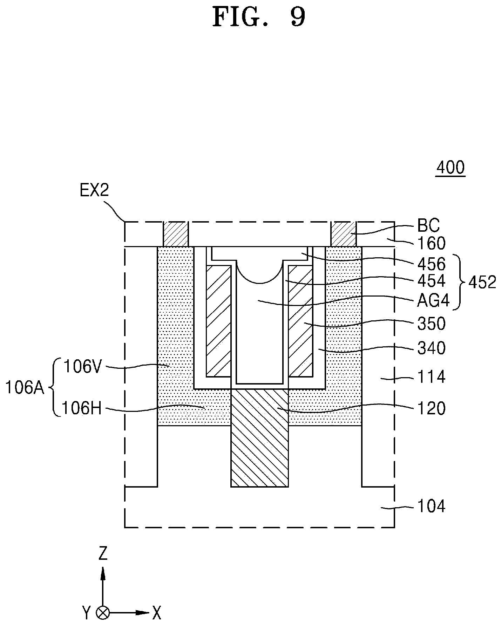

FIGS. 8 and 9 are cross-sectional views illustrating semiconductor memory devices 300 and 400 according to some embodiments, respectively. FIGS. 8 and 9 respectively illustrate enlarged cross-sectional views of some components in portions of the semiconductor memory devices 300 and 400, which correspond to the region EX1 of FIG. 1. In FIGS. 8 and 9, the same reference numerals as in FIGS. 1 to 6 respectively denote the same members, and here, repeated descriptions thereof are omitted.

Referring to FIG. 8, the semiconductor memory device 300 has substantially the same configuration as the semiconductor memory device 100 described with reference to FIGS. 1 to 6. However, the semiconductor memory device 300 includes a pair of word lines 350 arranged over one channel region 106A, a pair of gate dielectric films 340 arranged between the channel region 106A and the pair of word lines 350, and an upper insulating partition 352 arranged between the pair of word lines 350 and between the pair of gate dielectric films 340.

The upper insulating partition 352 may have substantially the same configuration as the plurality of upper insulating partitions 152 described with reference to FIGS. 2, 4, and 6. However, the upper insulating partition 352 may include a first upper insulating partition 354, which is in contact with the upper surface of the contact plug 120, and a second upper insulating partition 356, which is in contact with the upper surface of each of the first upper insulating partition 354 and the pair of word lines 350. The upper surface of the first upper insulating partition 354 and the upper surface of each of the pair of word lines 350 may form one flat surface.

More detailed configurations of the word line 350 and the gate dielectric film 340 may be substantially the same as those of the word line 150 and the gate dielectric film 140 described with reference to FIGS. 2 and 6, respectively.

Each of the first upper insulating partition 354 and the second upper insulating partition 356 may include a silicon oxide film, a silicon nitride film, or a combination thereof. In some embodiments, the first upper insulating partition 354 and the second upper insulating partition 356 may include the same insulating material. In some embodiments, the first upper insulating partition 354 and the second upper insulating partition 356 may respectively include different insulating materials.

Referring to FIG. 9, the semiconductor memory device 400 has substantially the same configuration as the semiconductor memory device 100 described with reference to FIGS. 1 to 6. However, the semiconductor memory device 400 includes a pair of word lines 350 arranged over one channel region 106A, a pair of gate dielectric films 340 arranged between the channel region 106A and the pair of word lines 350, and an upper insulating partition 452 arranged between the pair of word lines 350 and between the pair of gate dielectric films 340.

More detailed configurations of the word line 350 and the gate dielectric film 340 may be substantially the same as those of the word line 150 and the gate dielectric film 140 described with reference to FIGS. 2 and 6, respectively.

The upper insulating partition 452 may have substantially the same configuration as the plurality of upper insulating partitions 152 described with reference to FIGS. 2, 4, and 6. However, the upper insulating partition 452 may include an insulating liner 454, an insulating capping pattern 456, and an air gap AG4 defined by the insulating liner 454 and the insulating capping pattern 456. As used herein, the term "air" may refer to the atmosphere or to other gases that may be present during a fabrication process. The air gap AG4 may include the atmospheric gas or other gases that may be present during a manufacturing process.

In the upper insulating partition 452, the insulating liner 454 may be in contact with each of the upper surface of the contact plug 120, the pair of word lines 350, and the pair of gate dielectric films 340. The insulating capping pattern 456 may be in contact with an upper inner sidewall of the insulating liner 454. The upper surface of the gate dielectric film 340, the upper surface of the insulating liner 454, and the upper surface of the insulating capping pattern 456 may be in contact with the lower surface of the first insulating film 160.

Each of the insulating liner 454 and the insulating capping pattern 456, which are included in the upper insulating partition 452, may include a silicon oxide film, a silicon nitride film, or a combination thereof. In some embodiments, the insulating liner 454 and the insulating capping pattern 456 may include the same insulating material. In some embodiments, the insulating liner 454 and the insulating capping pattern 456 may respectively include different insulating materials.

Similar to the semiconductor memory device 100 described with reference to FIGS. 1 to 6, each of the semiconductor memory devices 200, 300, and 400 described with reference to FIGS. 7 to 9 may provide a structure, which facilitates the miniaturization and higher integration of memory cells and removes the possibility of an unintended short circuit between adjacent conductive regions, for example, the possibility of an unintended short circuit between the bit line BL and the channel region 106A adjacent thereto, even when components necessary to form a vertical channel transistor are arranged in a relatively small area due to the miniaturization and higher integration.

Next, a method of fabricating a semiconductor memory device, according to embodiments, is described.

FIGS. 10A to 24 are diagrams respectively illustrating a sequence of processes of a method of fabricating a semiconductor memory device, according to embodiments. More specifically, FIGS. 10A, 11A, 12A, 13A, 14A, 15A, 16A, 17A, and 18A are plan views each illustrating some components according to the sequence of processes of the method of fabricating a semiconductor memory device. FIGS. 10B, 14B, 15B, 16B, 17B, 18B, 19, 20, 21, 22A, 23, and 24 are cross-sectional views each illustrating a region corresponding to the cross-section taken along the line X1-X1' of FIG. 1, according to the sequence of processes. FIGS. 11B, 12B, 13B, 14C, 15C, 16C, and 17C are cross-sectional views each illustrating a region corresponding to the cross-section taken along the line X2-X2' of FIG. 1, according to the sequence of processes. FIGS. 11C, 12C, 13C, 14D, 15D, 16D, 17D, and 18C are cross-sectional views each illustrating a region corresponding to the cross-section taken along the line Y1-Y1' of FIG. 1, according to the sequence of processes. In each of FIGS. 10A, 11A, 12A, 13A, 14A, 15A, 16A, 17A, and 18A, the position of the cross-section taken along the line X1-X1' of FIG. 1, the cross-section taken along the line X2-X2' of FIG. 1, or the cross-section taken along the line Y1-Y1' of FIG. 1 is indicated. An example of a method of fabricating the semiconductor memory device 100 shown in FIGS. 1 to 6 is described with reference to FIGS. 10A to 24. In FIGS. 10A to 24, the same reference numerals as in FIGS. 1 to 4 respectively denote the same members, and here, repeated descriptions thereof are omitted.

Referring to FIGS. 10A and 10B, a silicon-on-insulator (SOI) substrate 101 may be prepared. The SOI substrate 101 may include a handle substrate 102, a base insulating film 104, and a semiconductor layer 106, which are stacked in the stated order in the vertical direction (the Z direction). The handle substrate 102 and the semiconductor layer 106 may each include silicon. The base insulating film 104 may include a silicon oxide film.

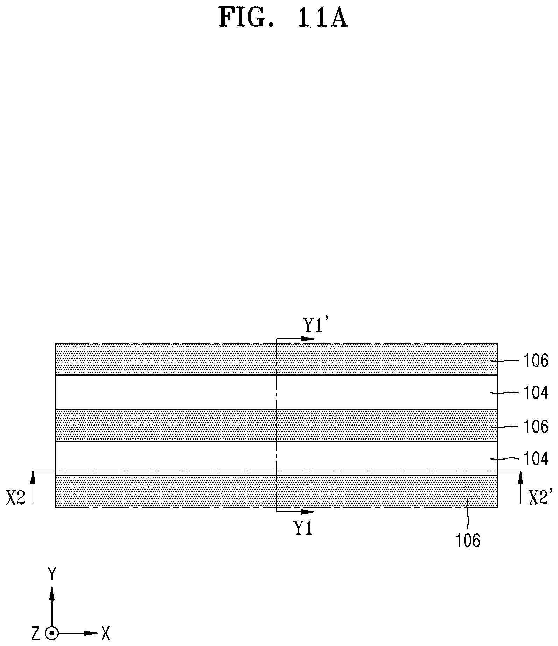

Referring to FIGS. 11A, 11B, and 11C, some regions of the base insulating film 104 may be exposed by removing some portions of the semiconductor layer 106 from the SOI substrate 101 shown in FIGS. 10A and 10B through anisotropic etching, followed by removing some portions of the base insulating film 104 by as much as a certain thickness from the regions of the base insulating film 104 through anisotropic etching, thereby forming a plurality of bit line spaces BLS.

The plurality of bit line spaces BLS may extend lengthwise in the first horizontal direction (the X direction and the -X direction) and may extend parallel to each other to be apart from each other in the second horizontal direction (the Y direction and the -Y direction). The base insulating film 104 may be exposed at the bottom and sidewalls of each of the plurality of bit line spaces BLS.

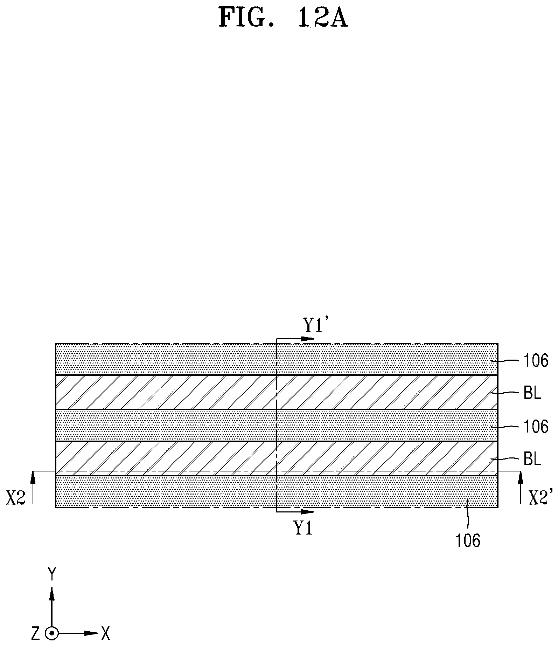

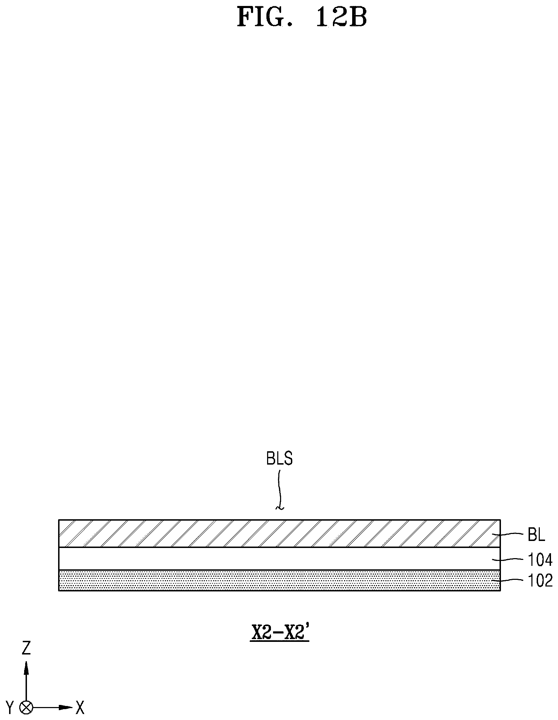

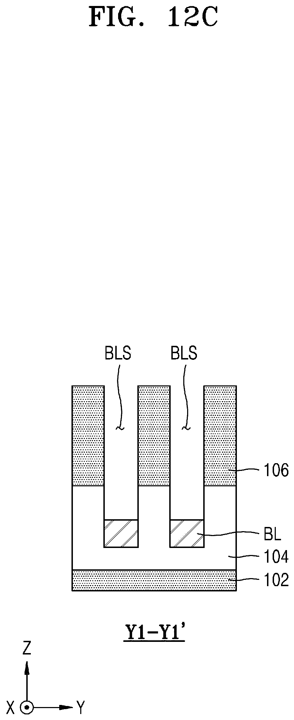

Referring to FIGS. 12A, 12B, and 12C, in the resulting product of FIGS. 11A, 11B, and 11C, a conductive layer may be formed to fill the plurality of bit line spaces BLS, followed by removing a portion of the conductive layer by etchback, thereby forming a plurality of bit lines BL respectively including portions of the conductive layer, the portions being respectively left in lower portions of the plurality of bit line spaces BLS. After the plurality of bit lines BL are formed, the base insulating film 104 may be exposed at the sidewall of each of the plurality of bit line spaces BLS remaining over the plurality of bit lines BL.

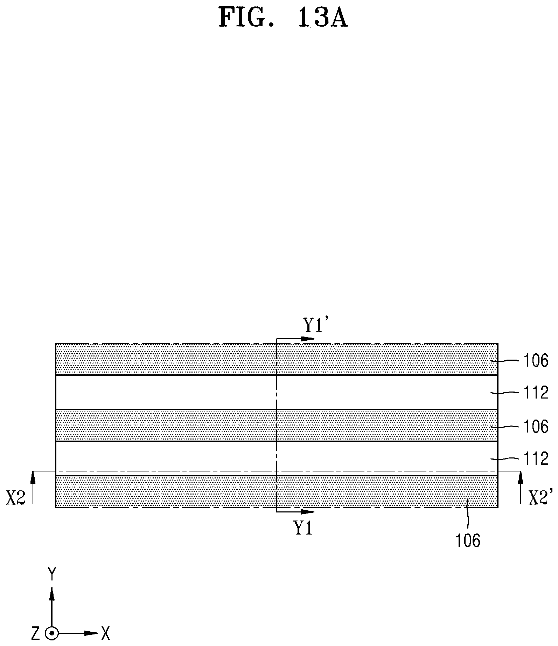

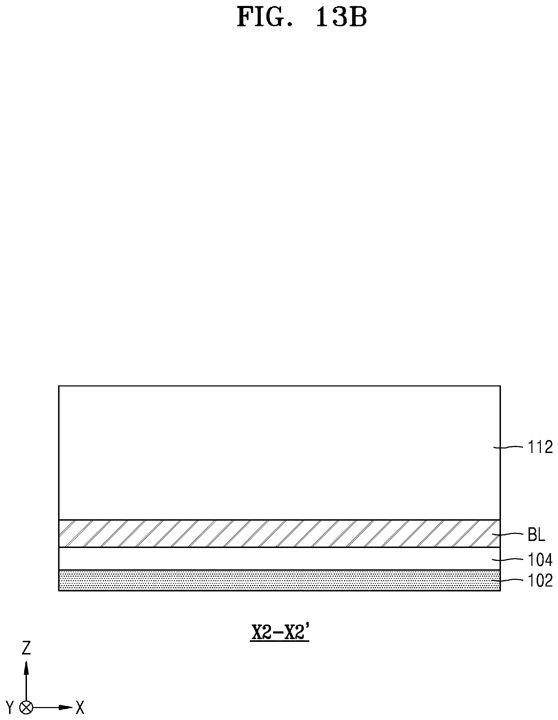

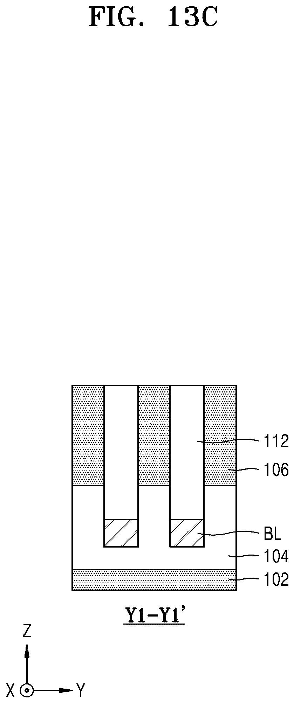

Referring to FIGS. 13A, 13B, and 13C, in the resulting product of FIGS. 12A, 12B, and 12C, a plurality of first isolation insulating films 112 may be formed to respectively fill the plurality of bit line spaces BLS remaining over the plurality of bit lines BL.

To form the plurality of first isolation insulating films 112, an insulating film may be formed to fill the plurality of bit line spaces BLS remaining over the plurality of bit lines BL and to cover the upper surface of the semiconductor layer 106, followed by planarizing an obtained result, thereby exposing the upper surface of the semiconductor layer 106. Portions of the insulating film, which are in the plurality of bit line spaces BLS, may respectively remain as the plurality of first isolation insulating films 112.

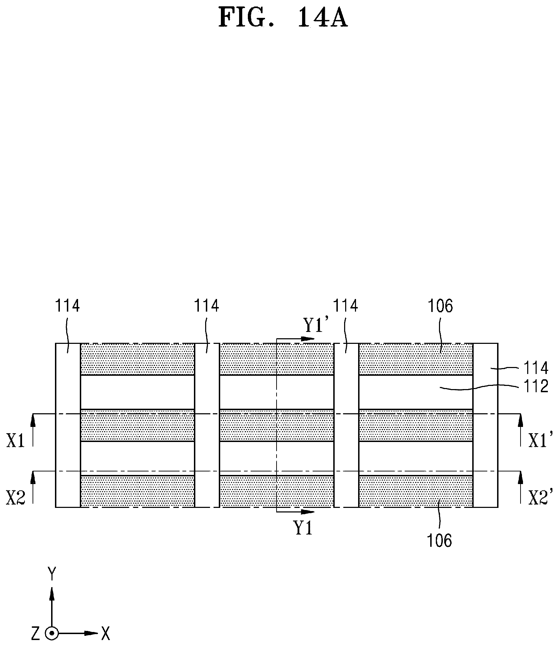

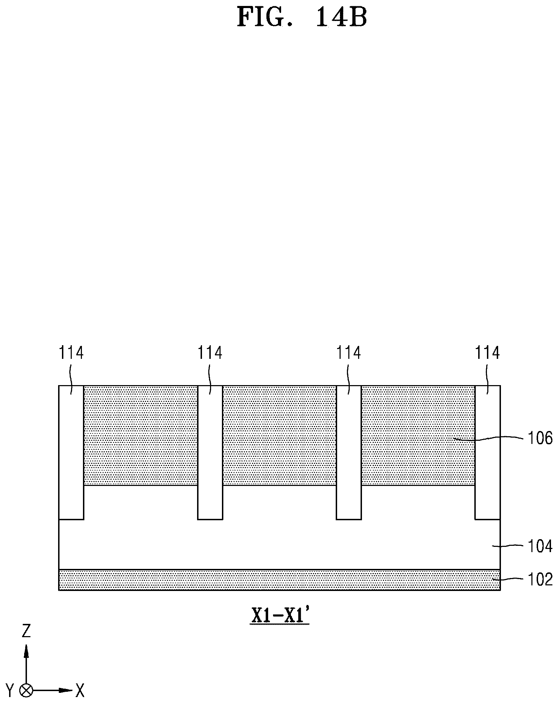

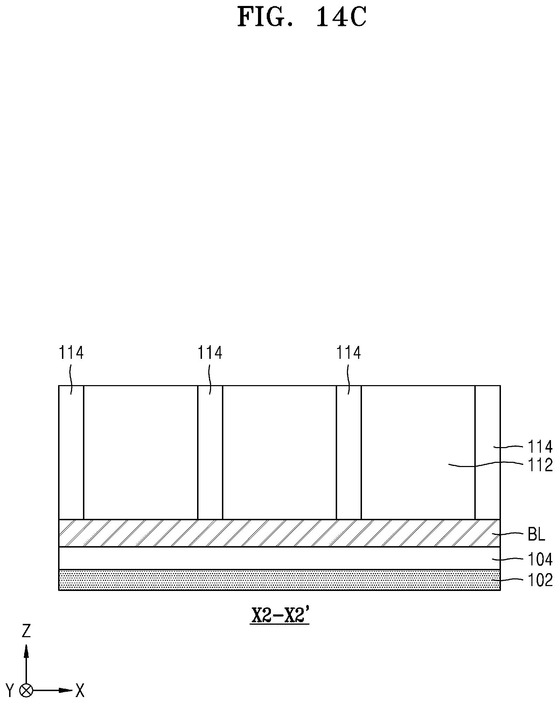

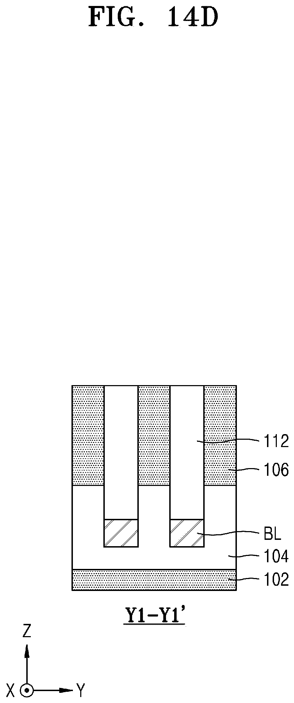

Referring to FIGS. 14A, 14B, 14C, and 14D, some portions of each of the semiconductor layer 106, the plurality of first isolation insulating films 112, and the base insulating film 104 may be removed from the resulting product of FIGS. 13A, 13B, and 13C through anisotropic etching, thereby forming a plurality of isolation spaces to expose portions of the base insulating films 104 and portions of each of the plurality of bit lines BL at the bottoms thereof, and then, the plurality of isolation spaces may be respectively filled with a plurality of second isolation insulating films 114.

The plurality of isolation spaces may extend lengthwise in the second horizontal direction (the Y direction and the -Y direction) and may extend parallel to each other to be apart from each other in the first horizontal direction (the X direction and the -X direction). Therefore, the plurality of second isolation insulating films 114, which respectively fill the plurality of isolation spaces, may extend lengthwise in the second horizontal direction (the Y direction and the -Y direction) and may extend parallel to each other to be apart from each other in the first horizontal direction (the X direction and the -X direction).

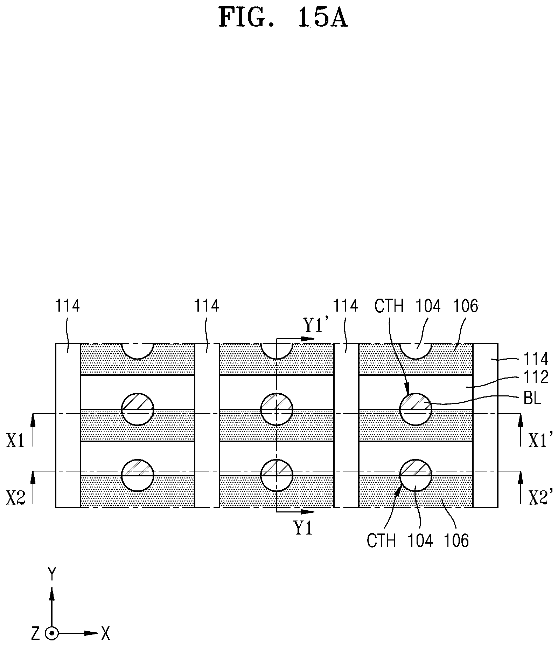

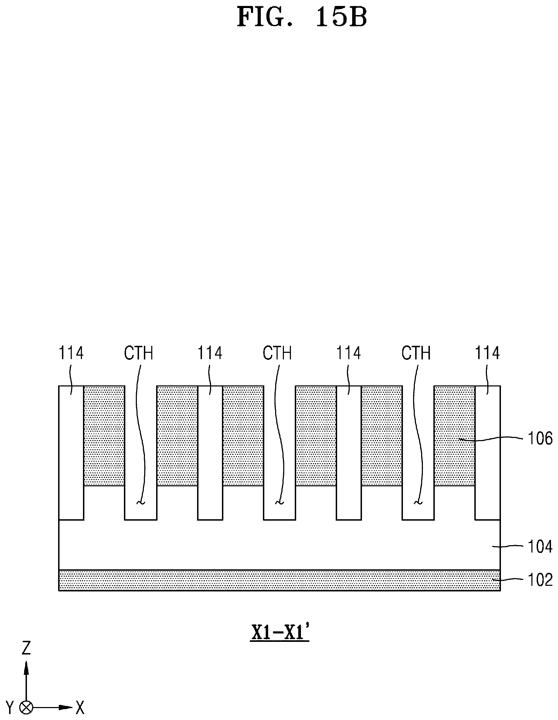

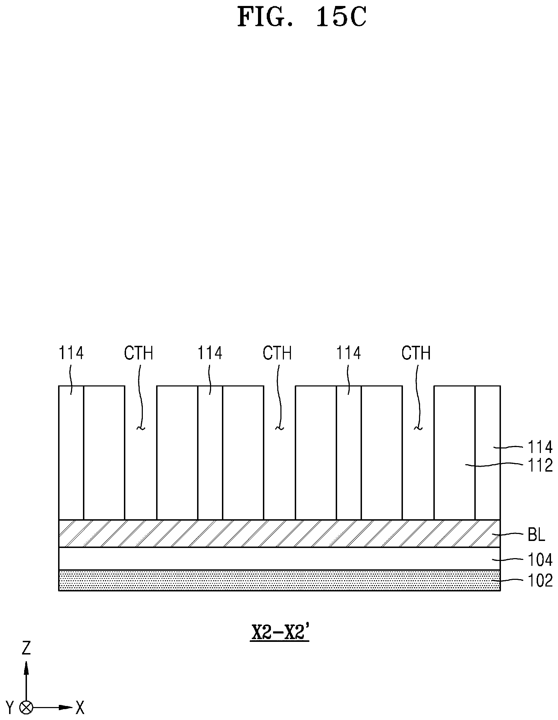

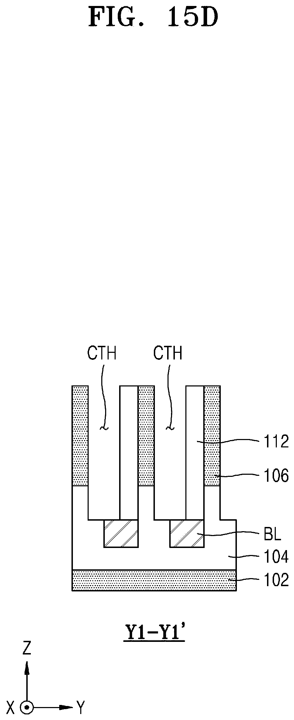

Referring to FIGS. 15A, 15B, 15C, and 15D, some portions of each of the semiconductor layer 106, the plurality of first isolation insulating films 112, and the base insulating film 104 may be removed from the resulting product of FIGS. 14A, 14B, 14C, and 14D through anisotropic etching, thereby forming a plurality of contact holes CTH to expose portions of the base insulating film 104 and portions of each of the plurality of bit lines BL at the bottoms thereof. A portion of the bit line BL and a portion of the base insulating film 104 may be exposed at the bottom of each of the plurality of contact holes CTH.

The plurality of contact holes CTH may be arranged at regular intervals in each of the first horizontal direction (the X direction and the -X direction) and the second horizontal direction (the Y direction and the -Y direction). The plurality of contact holes CTH may be arranged apart from the plurality of second isolation insulating films 114 in the first horizontal direction (the X direction and the -X direction).

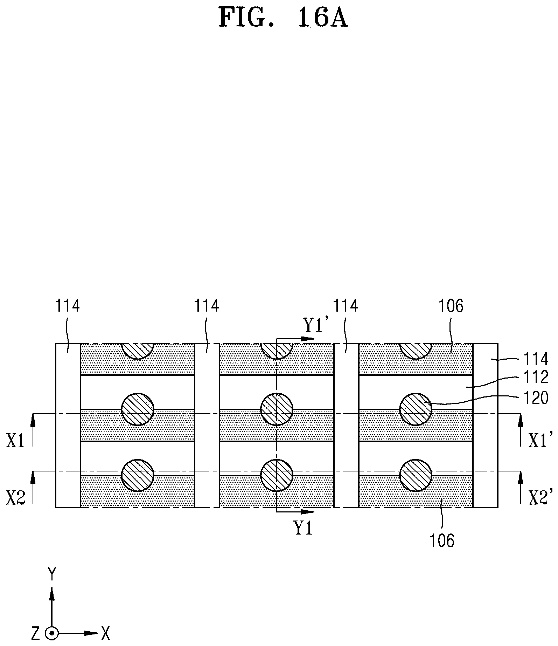

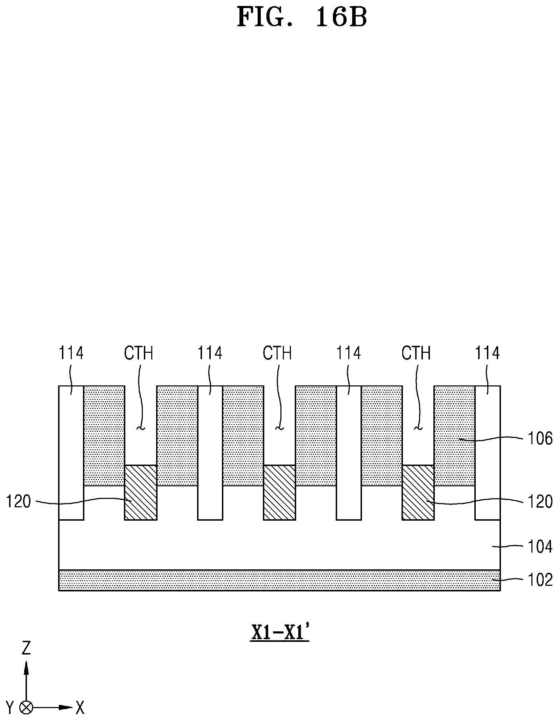

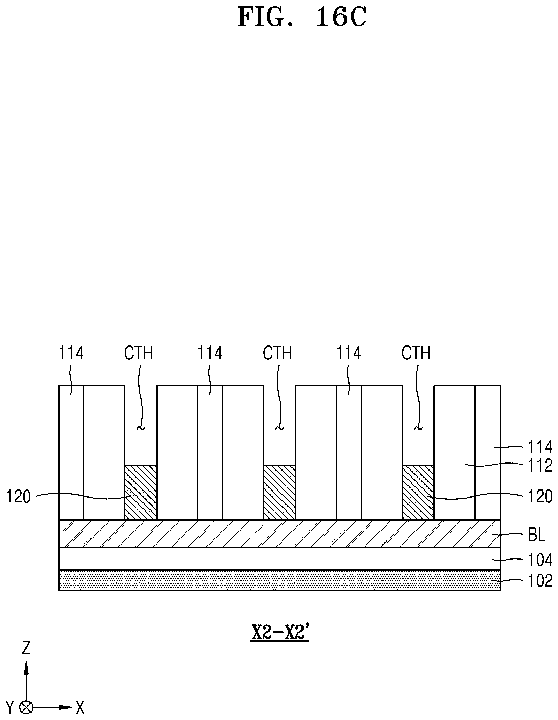

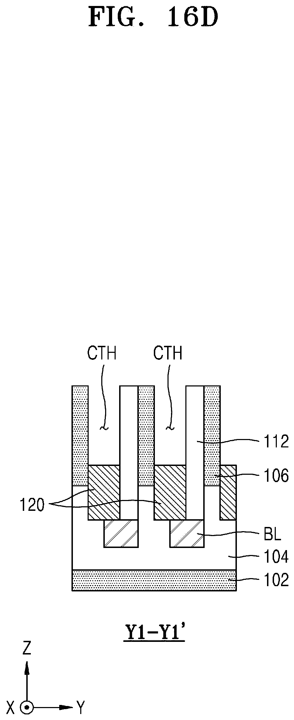

Referring to FIGS. 16A, 16B, 16C, and 16D, in the resulting product of FIGS. 15A, 15B, 15C, and 15D, a conductive layer may be formed to fill the plurality of contact holes CTH, followed by removing a portion of the conductive layer by etchback, thereby forming a plurality of contact plugs 120 respectively including portions of the conductive layer, the portions being respectively left in lower portions of the plurality of contact holes CTH. A vertical level of the upper surface of each of the plurality of contact plugs 120 may be higher than a vertical level of the lower surface of the semiconductor layer 106. Therefore, each of the plurality of contact plugs 120 may cover a lower sidewall of the semiconductor layer 106. After the plurality of contact plugs 120 are formed, the semiconductor layer 106 and the first isolation insulating film 112 may be exposed at the sidewall of each of the plurality of contact holes CTH remaining over the plurality of contact plugs 120.

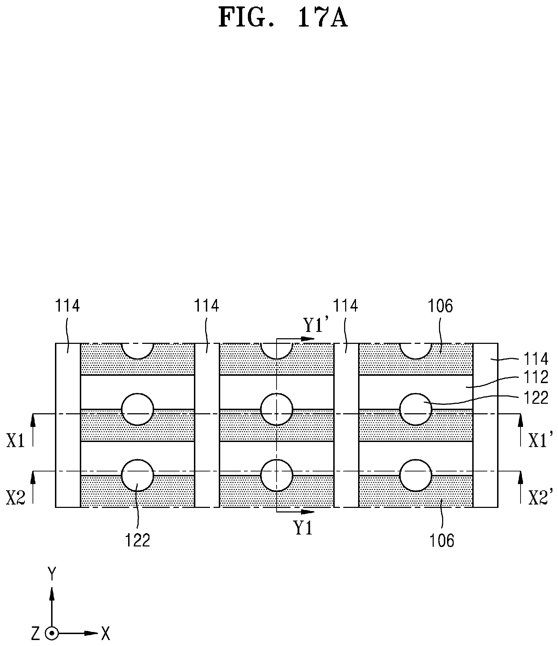

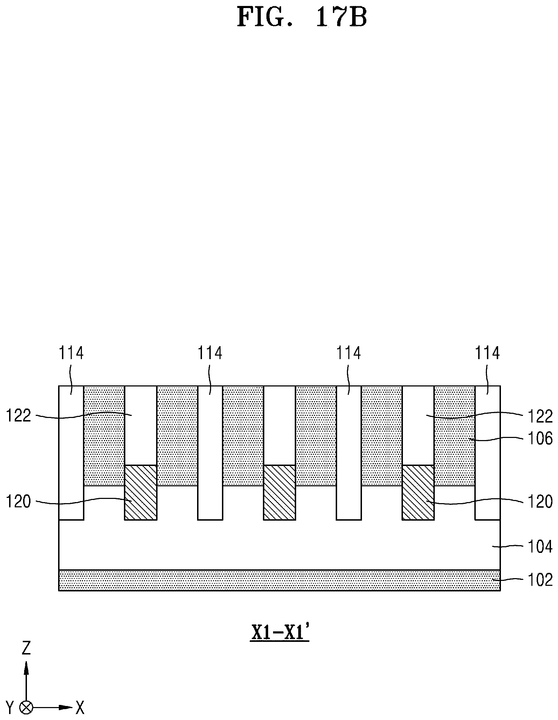

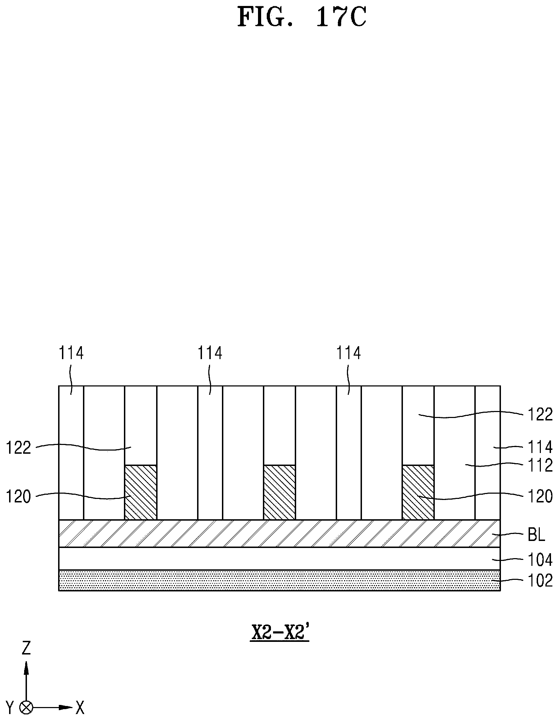

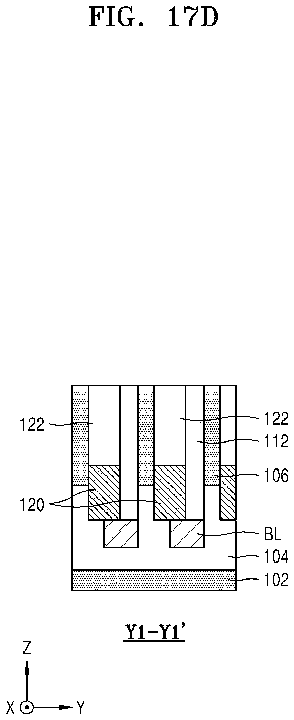

Referring to FIGS. 17A, 17B, 17C, and 17D, in the resulting product of FIGS. 16A, 16B, 16C, and 16D, a plurality of buried insulating films 122 may be formed to respectively fill remaining spaces of the plurality of contact holes CTH over the plurality of contact plugs 120. The plurality of buried insulating films 122 may respectively overlap the plurality of contact plugs 120 in the vertical direction (the Z direction) and may each have a cylindrical shape extending lengthwise in the vertical direction (the Z direction).

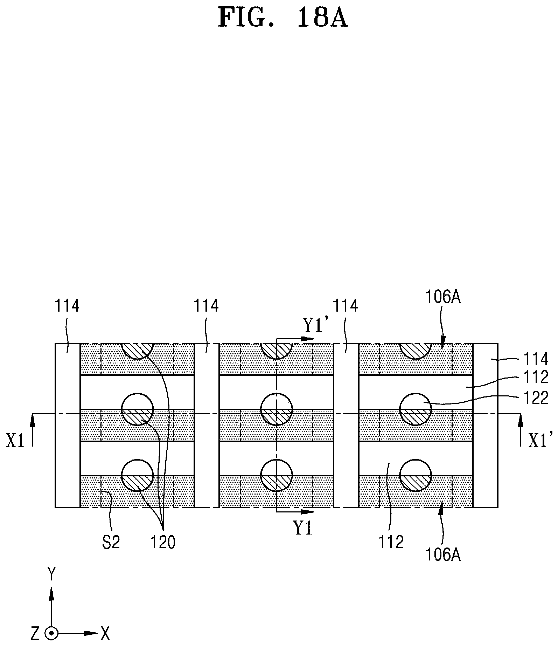

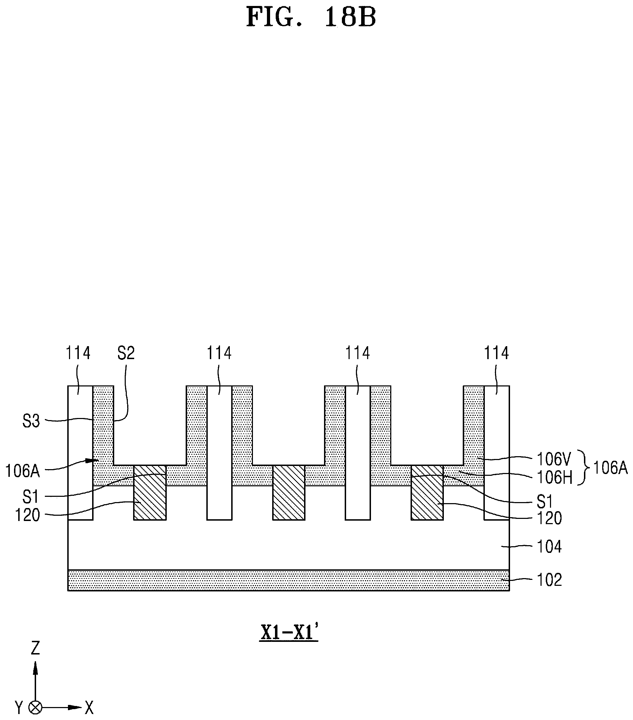

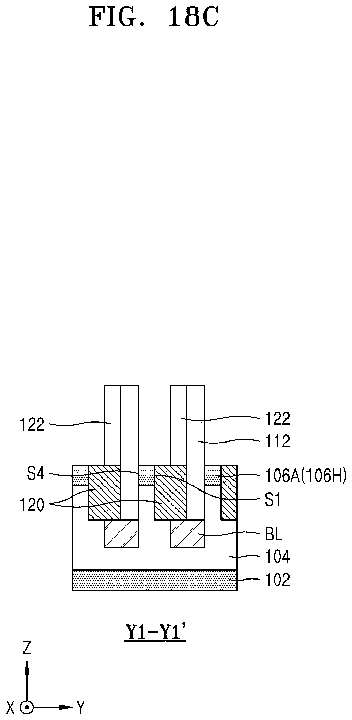

Referring to FIGS. 18A, 18B, and 18C, in the resulting product of FIGS. 17A, 17B, 17C, and 17D, a portion of the semiconductor layer 106 and a portion of each of the plurality of buried insulating films 122 may be patterned, whereby a plurality of channel regions 106A, which each include a horizontal channel region 106H and a vertical channel region 106V, may be formed from the semiconductor layer 106, and an upper surface of a portion of the contact plug 120 may be exposed, the portion being in contact with the horizontal channel region 106H of each of the plurality of channel regions 106A.

After the plurality of channel regions 106A are formed, an upper surface of a portion of the contact plug 120 may remain covered by the buried insulating film 122, the portion being not in contact with the horizontal channel region 106H of each of the plurality of channel regions 106A.

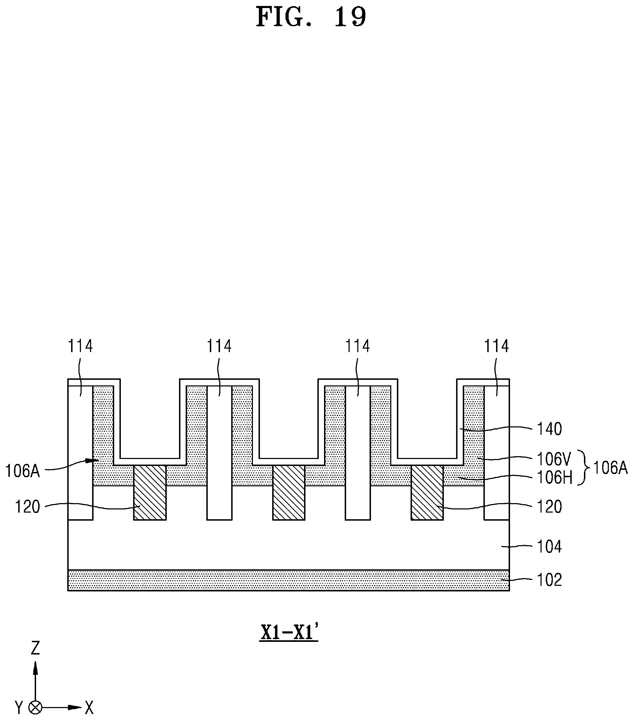

Referring to FIG. 19, a gate dielectric film 140 may be formed to conformally cover exposed surfaces in an upper portion of the resulting product of FIGS. 18A, 18B, and 18C.

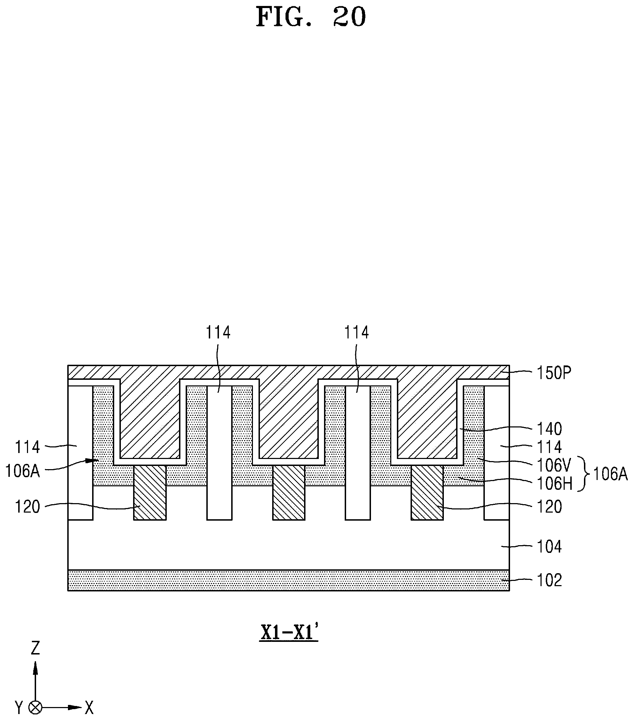

Referring to FIG. 20, a conductive material may be deposited on the resulting product having undergone the process of FIG. 19, thereby forming a conductive layer 150P, which fills spaces recessed from the upper surface of the resulting product of FIG. 19 and has a planarized upper surface.

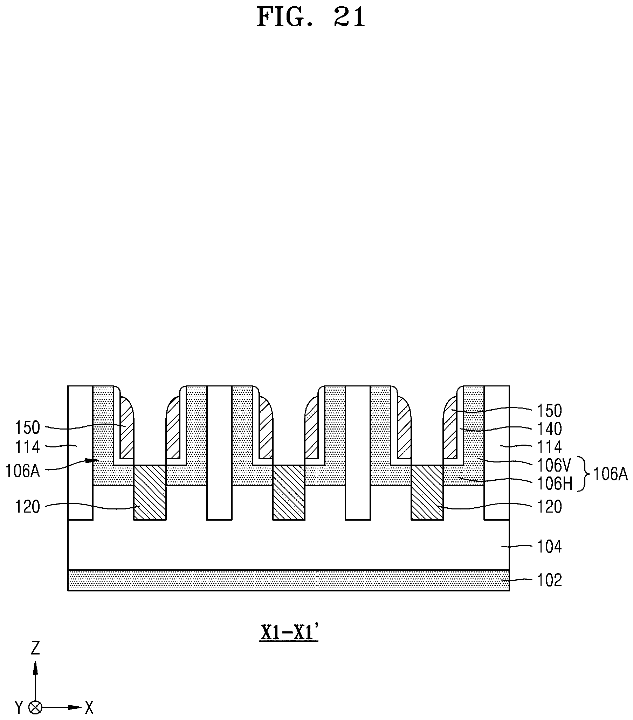

Referring to FIG. 21, a plurality of word lines 150 may be formed from the conductive layer 150P by patterning the conductive layer 150P, and then, a portion of the gate dielectric film 140, which is exposed around each of the plurality of word lines 150, may be removed, thereby exposing the upper surface of each of the plurality of channel regions 106A and the upper surface of each of the plurality of contact plugs 120. As a result, the gate dielectric film 140 may not cover the upper surface of each of the plurality of channel regions 106A and the upper surface of each of the plurality of second isolation insulating films 114 and may remain only in a region between the channel region 106A and the word line 150 and an adjacent region thereto in spaces defined by the plurality of channel regions 106A each having an approximately U-like cross-sectional shape.

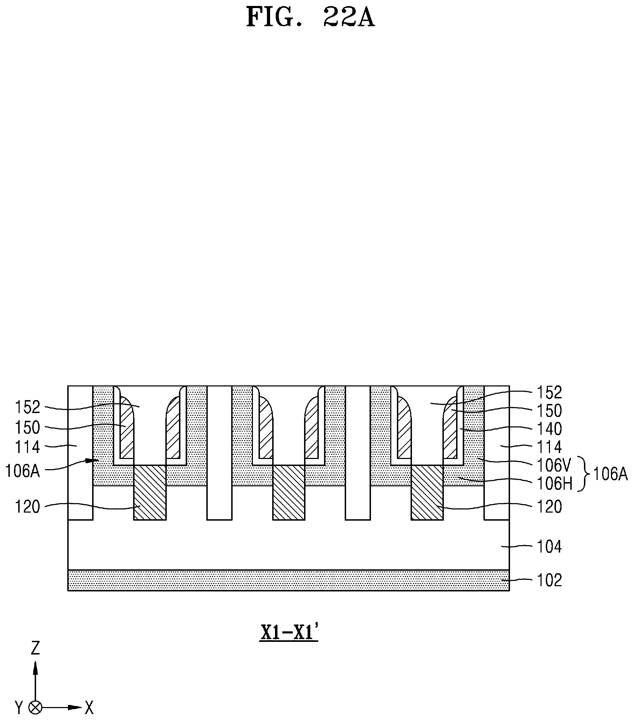

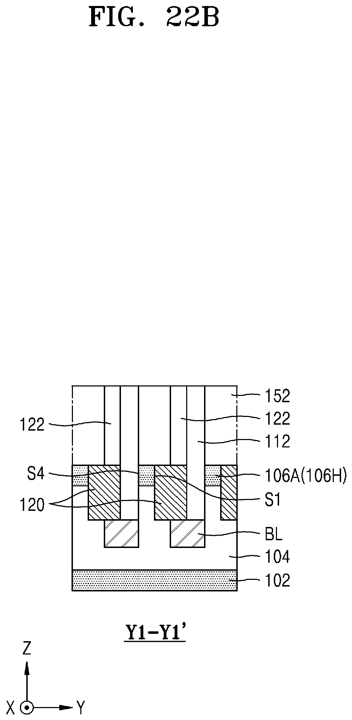

Referring to FIGS. 22A and 22B, in the resulting product having undergone the processes described with reference to FIG. 21, a plurality of upper insulating partitions 152 may be formed to respectively fill remaining portions of the spaces defined by the plurality of channel regions 106A each having an approximately U-like cross-sectional shape.

In some embodiments, to form the plurality of upper insulating partitions 152, an insulating film, which has a thickness sufficient to fill the remaining portion of the space defined by the channel region 106A, may be formed on the resulting product having undergone the processes described with reference to FIG. 21, and then, the insulating film may be planarized to expose the upper surface of each of the plurality of first isolation insulating films 112, the plurality of second isolation insulating films 114, and the plurality of buried insulating films 122.

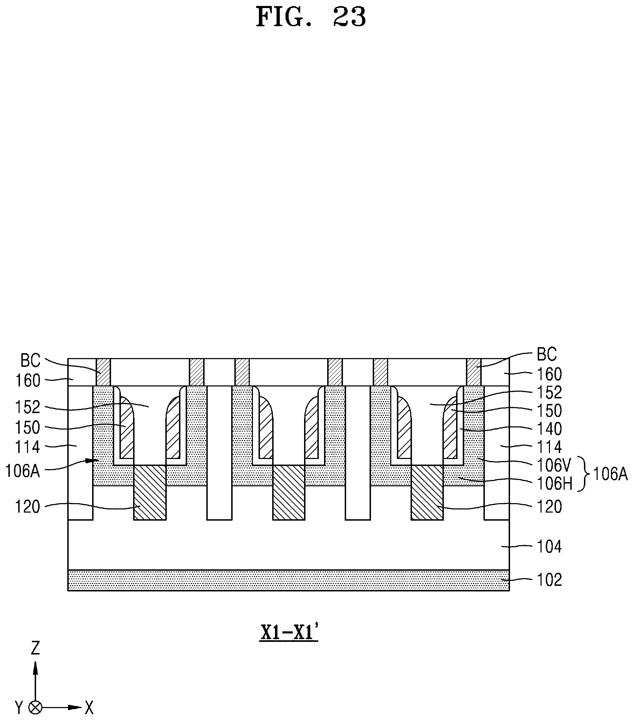

Referring to FIG. 23, a first insulating film 160 may be formed on the resulting product having undergone the processes described with reference to FIGS. 22A and 22B, and a plurality of upper contact patterns BC may be formed to pass through the first insulating film 160 in the vertical direction (the Z direction).

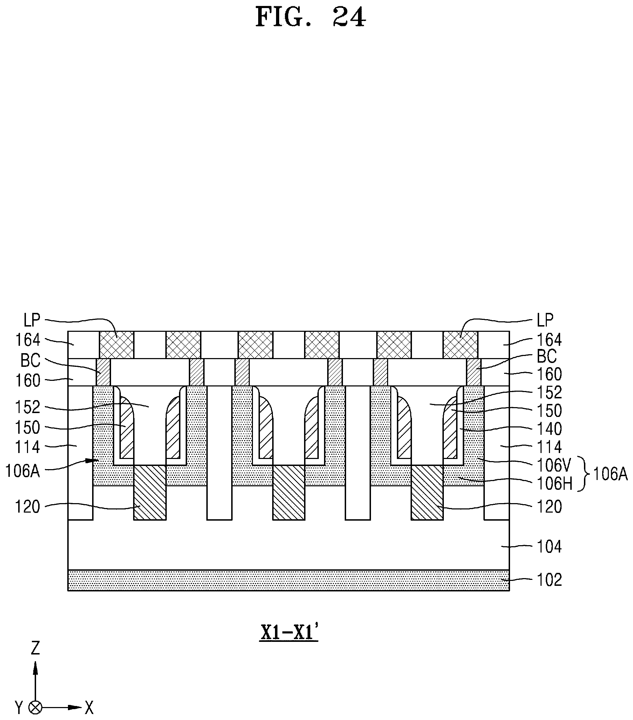

Referring to FIG. 24, a second insulating film 164 may be formed on the resulting product having undergone the processes described with reference to FIG. 23, and a plurality of conductive landing pads LP may be formed to pass through the second insulating film 164 in the vertical direction (the Z direction).

Next, as shown in FIGS. 2, 3, and 4, an etch stop film 172 and an interlayer dielectric 174 may be formed on or over the resulting product in which the plurality of conductive landing pads LP are formed, followed by forming a plurality of capacitor structures CAP, which pass through the etch stop film 172 and the interlayer dielectric 174 and are respectively connected to the plurality of conductive landing pads LP, and then, the handle substrate 102 may be removed, thereby forming the semiconductor memory device 100 shown in FIGS. 1 to 6. In some embodiments, the handle substrate 102 may remain to cover the lower surface of the base insulating film 104 without being removed.

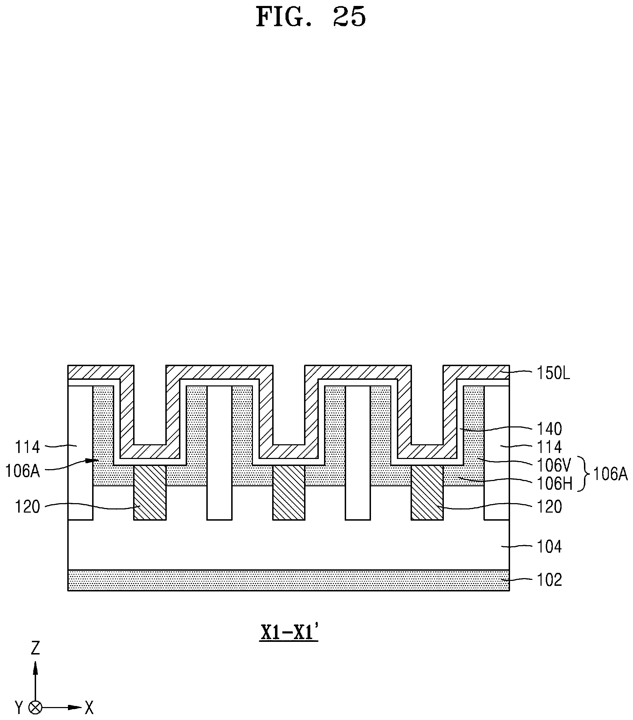

FIG. 25 is a cross-sectional view illustrating a method of fabricating a semiconductor memory device, according to some embodiments. FIG. 25 illustrates a cross-sectional configuration of a region corresponding to the cross-section taken along the line X1-X1' of FIG. 1 according to a sequence of processes. Another example of the method of fabricating the semiconductor memory device 100 shown in FIGS. 1 to 6 is described with reference to FIG. 25. In FIG. 25, the same reference numerals as in FIGS. 1 to 24 respectively denote the same members, and here, repeated descriptions thereof are omitted.

Referring to FIG. 25, the processes described with reference to FIGS. 10A to 19 may be performed. Next, a conductive thin-film 150L may be formed to conformally cover the exposed upper surface of the resulting product having undergone the process of FIG. 19. After the conductive thin-film 150L is formed, portions of the spaces defined by the plurality of channel regions 106A, each having an approximately U-like cross-sectional shape, may remain empty over the conductive thin-film 150L.

Next, a plurality of word lines 150 (see FIGS. 2 and 21) may be formed by performing etchback on the conductive thin-film 150L, followed by exposing the upper surface of each of the plurality of channel regions 106A and the upper surface of each of the plurality of contact plugs 120 by removing an exposed portion of the gate dielectric film 140 around each of the plurality of word lines 150, thereby forming a structure that is identical or similar to the example shown in FIG. 21.

Next, the processes described with reference to FIGS. 22A to 24 may be performed, thereby fabricating the semiconductor memory device 100 shown in FIGS. 1 to 6.

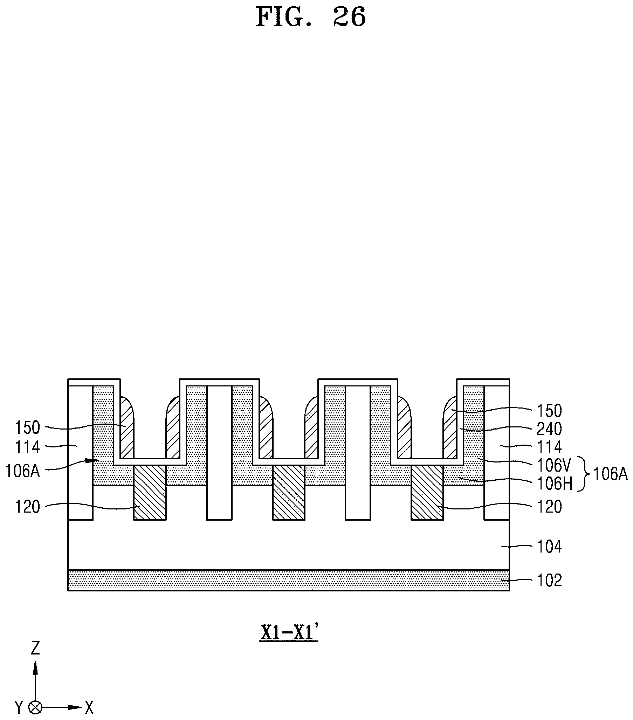

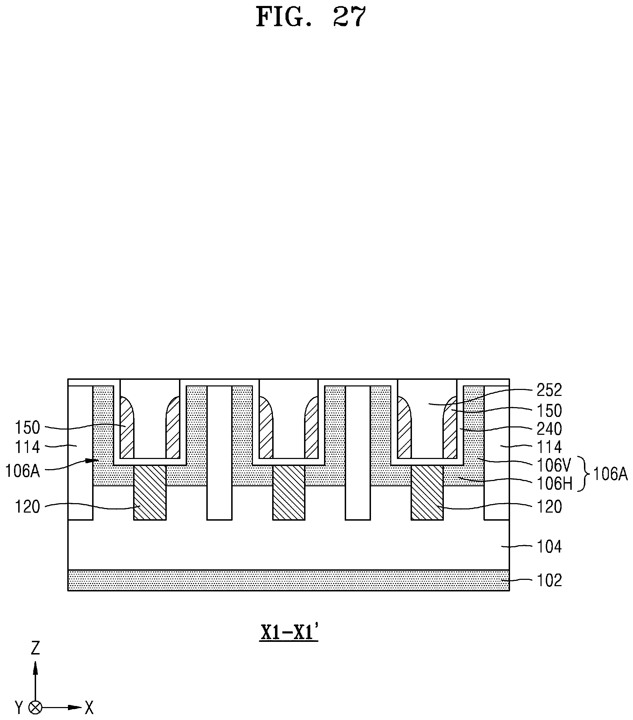

FIGS. 26 and 27 are cross-sectional views respectively illustrating a sequence of processes of a method of fabricating a semiconductor memory device, according to some embodiments. FIGS. 26 and 27 each illustrate a cross-sectional configuration of a region corresponding to the cross-section taken along the line X1-X1' of FIG. 1 according to the sequence of processes. An example of a method of fabricating the semiconductor memory device 200 shown in FIG. 7 is described with reference to FIGS. 26 and 27. In FIGS. 26 and 27, the same reference numerals as in FIGS. 1 to 24 respectively denote the same members, and here, repeated descriptions thereof are omitted.

Referring to FIG. 26, the processes described with reference to FIGS. 10A to 20 may be performed. However, in the present example, a gate dielectric film 240 may be formed instead of the gate dielectric film 140. Next, similar to the description made with reference to FIG. 21, a plurality of word lines 150 may be formed from the conductive layer 150P by patterning the conductive layer 150P. After the plurality of word lines 150 are formed, the gate dielectric film 240 may be exposed around each of the plurality of word lines 150. The gate dielectric film 240 may be maintained to cover the upper surface of each of the plurality of channel regions 106A and the upper surface of each of the plurality of contact plugs 120.

Referring to FIG. 27, similar processes to those described with reference to FIGS. 22A and 22B may be performed on the resulting product having undergone the process of FIG. 26, thereby forming a plurality of upper insulating partitions 252, which respectively fill remaining portions of the spaces defined by the plurality of channel regions 106A that each have an approximately U-like cross-sectional shape.

Next, by performing similar processes to those described with reference to FIG. 23, a first insulating film 160 may be formed on the resulting product having undergone the process of FIG. 27, and a plurality of upper contact patterns BC2 (see FIG. 7) may be formed to pass through the first insulating film 160 in the vertical direction (the Z direction). However, each of the plurality of upper contact patterns BC2 may be formed to pass through the first insulating film 160 and the gate dielectric film 240 in the vertical direction (the Z direction) to be in contact with the uppermost surface of a vertical channel region 106V that is included in a channel region 106A adjacent to each upper contact pattern BC2 from among the plurality of channel regions 106A. Next, the processes described with reference to FIG. 24 may be performed, thereby fabricating the semiconductor memory device 200 shown in FIG. 7.

Heretofore, while the examples of the methods of respectively fabricating the semiconductor memory devices 100 and 200 shown in FIGS. 1 to 7 have been described with reference to FIGS. 10A to 27, it will be understood by those of ordinary skill in the art that, by making various modifications and changes to the examples described with reference to FIGS. 10A to 27, the semiconductor memory devices 300 and 400 shown in FIGS. 8 and 9 and semiconductor memory devices having various structures modified and changed from the semiconductor memory devices 100, 200, 300, and 400 without departing from the spirit and scope of inventive concepts may be fabricated.

For example, to fabricate the semiconductor memory device 300 shown in FIG. 8, the processes described with reference to FIGS. 10A to 19 may be performed. However, in the process described with reference to FIG. 19, a gate dielectric film 340 may be formed instead of the gate dielectric film 140. Next, a pair of word lines 350 and a first upper insulating partition 354 (see FIG. 8) between the pair of word lines 350 may be formed on the gate dielectric film 340 in each of the spaces defined by the plurality of channel regions 106A that each have an approximately U-like cross-sectional shape. The pair of word lines 350 and the first upper insulating partition 354 may each be formed to have a planarized upper surface.

Next, a second upper insulating partition 356 may be formed to cover the upper surface of each of the first upper insulating partition 354 and the pair of word lines 350, and a portion of the gate dielectric film 340, which is exposed around the second upper insulating partition 356, may be removed, thereby exposing the upper surface of each of the plurality of channel regions 106A and the upper surface of each of the plurality of contact plugs 120. The processes described with reference to FIGS. 23 and 24 may be performed on the resulting product obtained as such, thereby fabricating the semiconductor memory device 300 described with reference to FIG. 8.

To fabricate the semiconductor memory device 400 shown in FIG. 9, substantially similar processes to those in the description of the method of fabricating the semiconductor memory device 300 shown in FIG. 8 may be performed. However, after the first upper insulating partition 354 is formed as described above, the first upper insulating partition 354 may be removed again, thereby exposing the upper surface of the contact plug 120 and the sidewalls of the pair of word lines 350 in the space defined by the channel region 106A having an approximately U-like shape. Next, an insulating liner 454 may be formed to conformally cover the upper surface of the contact plug 120, the surfaces of the pair of word lines 350, and the surface of the gate dielectric film 340, and an insulating capping pattern 456 may be formed on the resulting product, in which the insulating liner 454 is formed, by a deposition process exhibiting relatively low step coverage characteristics. As a result, an air gap AG4 may be formed to be defined by the insulating liner 454 and the insulating capping pattern 456. The processes described with reference to FIGS. 23 and 24 may be performed on the resulting product obtained as such, thereby fabricating the semiconductor memory device 400 described with reference to FIG. 9.

While inventive concepts has been particularly shown and described with reference to embodiments thereof, it will be understood that various changes in form and details may be made therein without departing from the scope of the following claims.

## Claims

1. A semiconductor memory device comprising:
a bit line (BL) extending lengthwise in a first horizontal direction (X) on a first plane;
a channel structure (106A) on a second plane that is apart from the first plane in a vertical direction (Z), the channel structure (106A) being shifted from the bit line (BL) in a second horizontal direction (Y) in a plan view and not overlapping the bit line (BL) in the vertical direction (Z), and the second horizontal direction (Y) being orthogonal to the first horizontal direction (X);
an insulating structure (104, 112, 114) between the bit line (BL) and the channel structure (106A), the insulating structure (104, 112, 114) filling a space between the first plane and the second plane; and
a contact plug (120) passing through the insulating structure (104, 112, 114) in the vertical direction (Z), a bottom surface of the contact plug (120) being in contact with an upper surface of the bit line (BL), and an upper sidewall of the contact plug (120) being in contact with the channel structure (106A).

2. The semiconductor memory device of claim 1, wherein
the contact plug (120) comprises a first plug portion (120A) and a second plug portion (120B) integrally connected to the first plug portion (120A),
the first plug portion (120A) overlaps the bit line (BL) in the vertical direction (Z),
the second plug portion (120B) does not overlap the bit line (BL) in the vertical direction (Z) and the second plug portion (120B) does not overlap the channel structure (106A) in the vertical direction (Z),
the channel structure (106A) is in contact with an upper sidewall of the second plug portion (120B), and
the channel structure (106A) is not in contact with the first plug portion (120A).

3. The semiconductor memory device of claim 1 or 2, further comprising:
a word line (150; 350) on a third plane, a surface of the word line (150; 350) facing the channel structure (106A) in the first horizontal direction (X), the third plane being apart from the second plane in a direction away from the bit line (BL) in the vertical direction (Z); and
a gate dielectric film (140; 240; 340) between the channel structure (106A) and the word line (150; 350),
wherein the word line (150; 350) and the gate dielectric film (140; 240; 340) are each shifted from the bit line (BL) in the second horizontal direction (Y) in a plan view such that the word line (150; 350) and the gate dielectric film (140; 240; 340) do not to overlap the bit line (BL) in the vertical direction (Z).

4. The semiconductor memory device of any one of claims 1 to 3, wherein
the channel structure (106A) comprises a horizontal channel portion (106H) and a vertical channel portion (106V) integrally connected to the horizontal channel portion (106H),
the horizontal channel portion (106H) extends in the first horizontal direction (X) along the second plane and the horizontal channel portion (106H) includes a nonlinear recess sidewall (S1) in contact with the upper sidewall of the contact plug (120),
the vertical channel portion (106V) extends from an end of the horizontal channel portion (106H) in a direction away from the bit line (BL) in the vertical direction (Z).

5. The semiconductor memory device of claim 3, wherein
the channel structure (106A) comprises a horizontal channel portion (106H) and a vertical channel portion (106V) integrally connected to the horizontal channel portion (106H),
the horizontal channel portion (106H) extends in the first horizontal direction (X) along the second plane and the horizontal channel portion (106H) includes a nonlinear recess sidewall (S1) in contact with the upper sidewall of the contact plug (120),
the vertical channel portion (106V) extends from an end of the horizontal channel portion (106H) in a direction away from the bit line (BL) in the vertical direction (Z),
a first portion (L1) of the horizontal channel portion (106H) does not overlap the contact plug (120) in the second horizontal direction (Y),
a second portion (L2) of the horizontal channel portion (106H) overlaps the contact plug (120) in the second horizontal direction (Y),
the gate dielectric film (140; 340) is in contact with a surface of the vertical channel portion (106V) and a surface of the first portion (L 1) of the horizontal channel portion (106H), and
the gate dielectric film (140; 340) is not in contact with a surface of the second portion (L2) of the horizontal channel portion (106H).

6. The semiconductor memory device of claim 3, wherein
the channel structure (106A) comprises a horizontal channel portion (106H) and a vertical channel portion integrally connected to the horizontal channel portion (106H),
the horizontal channel portion (106H) extends in the first horizontal direction (X) along the second plane and the horizontal channel portion (106H) includes a nonlinear recess sidewall (S1) in contact with the upper sidewall of the contact plug (120),
the vertical channel portion (106V) extends from an end of the horizontal channel portion (106H) in a direction away from the bit line (BL) in the vertical direction (Z),
the gate dielectric film (240) contacts a surface of the vertical channel portion (106V), a surface of the horizontal channel portion (106H), and an upper surface of the contact plug (120).

7. The semiconductor memory device of any one of claims 1 to 6, further comprising:
an upper contact pattern (BC; BC2) in contact with an uppermost surface of the channel structure (106A), the uppermost surface being a farthest surface in the channel structure (106A) from the bit line (BL); and
a capacitor structure (CAP) connected to the upper contact pattern (BC; BC2).

8. The semiconductor memory device of claim 1,
wherein the contact plug (120) comprises a first plug portion (120A) and a second plug portion (120B) integrally connected to the first plug portion (120A),
the first plug portion (120A) overlaps the bit line (BL) in the vertical direction (Z), and
the second plug portion (120B) does not overlap the bit line (BL) in the vertical direction (Z) and does not overlap the channel structure (106A) in the vertical direction (Z),
wherein the insulating structure (104, 112, 114) comprises a base insulating film (104), a first isolation insulating film (112), and a second isolation insulating film (114),
the base insulating film (104) covers a lower surface of the bit line (BL), a sidewall of the bit line (BL), a lower surface of the second plug portion (120B), and a sidewall of the second plug portion (120B),
the first isolation insulating film (112) contacts an upper surface of the bit line (BL), a sidewall of the first plug portion (120A), and a first portion of the channel structure (106A), and
the second isolation insulating film (114) contacts the upper surface of the bit line (BL) and a second portion of the channel structure (106A).

9. The semiconductor memory device of claim 1 or 2, further comprising:
a word line (150; 350) having a surface facing the channel structure (106A) in the first horizontal direction (X);
a gate dielectric film (140; 240; 340) between the channel structure (106A) and the word line (150; 350); and
an upper insulating partition (152; 252; 352; 452) on the contact plug (120), wherein
a first portion of the upper insulating partition (152; 252; 352; 452) overlaps a portion of the contact plug (120) in the vertical direction (Z) and a second portion of the upper insulating partition (152; 252; 352; 452) overlaps a portion of the channel structure (106A) in the vertical direction (Z),
wherein the word line (150; 350), the gate dielectric film (140; 240; 340), and the upper insulating partition (152; 252; 352; 452) each are shifted from the bit line (BL) in the second horizontal direction (Y) in a plan view not to overlap the bit line (BL) in the vertical direction (Z).

10. The semiconductor memory device of claim 9, wherein the upper insulating partition (452) comprises an air gap (AG4).

11. The semiconductor memory device claim 1 or 2, further comprising:
a base insulating film (104); and
a memory cell array including a plurality of memory cells repeatedly arranged on the base insulating film (104) in the first horizontal direction (X) and the second horizontal direction (Y),
wherein the memory cell array includes
a plurality of bit lines (BL) in the base insulating film (104) and each extending lengthwise in the first horizontal direction (X) on a first plane on the base insulating film (104), the plurality of bit lines (BL) being apart from each other in the second horizontal direction (Y),
a plurality of channel structures (106A) repeatedly arranged in the first horizontal direction (X) and the second horizontal direction (Y) on a second plane that is apart from the first plane on the base insulating film (104) in the vertical direction (Z), and
a plurality of contact plugs (120) passing through the insulating structure (104, 112, 114) in the vertical direction (Z),
wherein the insulating structure (104, 112, 114) is between the plurality of bit lines (BL) and the plurality of channel structures (106A),
wherein a bottom surface of each of the plurality of contact plugs (120) is in contact with an upper surface of an underlying bit line (BL) among the plurality of bit lines (BL), and an upper sidewall of each of the plurality of contact plugs (120) is in contact with an adjacent one of the plurality of channel structures (106A), and
wherein each of the plurality of channel structures (106A) is shifted in the second horizontal direction (Y) from an adjacent one of the plurality of bit lines (BL) and does not to overlap the adjacent one of the plurality of bit lines (BL) in the vertical direction (Z).

12. The semiconductor memory device of claim 11, wherein
each of the plurality of contact plugs (120) comprises a first plug portion (120A) and a second plug portion (120B) integrally connected to the first plug portion (120A),
the first plug portion (120A) overlaps the underlying bit line (BL) among the plurality of bit lines (BL),
the second plug portion (120B) does not overlap one of the plurality of bit lines (BL) in the vertical direction (Z) and does not overlap one of the plurality of channel structures (106A) in the vertical direction (Z).

13. The semiconductor memory device of claim 12, wherein
each of the plurality of channel structures (106A) has a nonlinear recess sidewall (S1) that is in contact with the second plug portion (120B) of one of the plurality of contact plugs (120), and
each of the plurality of channel structures (106A) is not in contact with the first plug portion (120A) of one of the plurality of contact plugs (120).

14. The semiconductor memory device of any one of claims 11 to 13, wherein
each of the plurality of channel structures (106A) comprises a horizontal channel portion (106H) extending in the first horizontal direction (X) along the second plane and a pair of vertical channel portions integrally connected to the horizontal channel portion (106H),
the horizontal channel portion (106H) is in contact with the upper sidewall of one contact plug selected from the plurality of contact plugs (120),
the pair of vertical channel portions (106V) respectively extend from both ends of the horizontal channel portion (106H) in a direction away from the horizontal channel portion (106H) in the vertical direction (Z),
the both ends of the horizontal channel portion (106H) are based on the first horizontal direction (X), and
in the memory cell array, two adjacent memory cells in the first horizontal direction (X) from among the plurality of memory cells share a corresponding channel structure (106A) among the plurality of channel structures (106A) and a share a corresponding contact plug among the plurality of contact plugs (120), and
in the two adjacent memory cells, the corresponding contact plug in contact with the corresponding channel structure (106A).

15. The semiconductor memory device of any one of claims 11 to 14, further comprising:
a plurality of word lines (150; 350) respectively over the plurality of channel structures (106A); and
a plurality of gate dielectric films (140; 240; 340) between the plurality of channel structure (106A) and the plurality of word lines (150; 350),
wherein each of the plurality of word lines (150; 350) faces one channel structure (106A) closest thereto in the first horizontal direction (X) from among the plurality of channel structures (106A), and
each of the plurality of word lines (150; 350) and the plurality of gate dielectric films (140; 240; 340) is shifted from an adjacent bit line (BL) among the plurality of bit lines (BL) in the second horizontal direction (Y) in a plan view and does not to overlap the adjacent bit line (BL) in the vertical direction (Z).
